# EUROPEAN PATENT APPLICATION

(11) **EP 4 769 062 A1**
(43) Date of publication of application: **01.07.2026**
(21) Application number: 24888923.0
(22) Date of filing: 13.09.2024
(51) Int. Cl.: G06F 1/16

(54) **ELECTRONIC DEVICE COMPRISING HINGE DEVICE**

(30) Priority: 09.11.2023 KR 20230154652; 25.01.2024 KR 20240011711
(71) Applicant: Samsung Electronics Co., Ltd., Suwon-si, Gyeonggi-do 16677 (KR)
(72) Inventor: CHOI, Soobin, Suwon-si, Gyeonggi-do 16677 (KR); KIM, Jongyoon, Suwon-si, Gyeonggi-do 16677 (KR)
(74) Representative: Nederlandsch Octrooibureau
(86) International application number: PCT/KR2024/014040
(87) International publication number: WO 2025/100727

(57) **Abstract**

An electronic device according to an embodiment of the present disclosure comprises: a housing comprising a first housing and a second housing; a flexible display arranged in the first housing and the second housing; and a hinge device which connects the first housing and the second housing to be rotatable with respect to each other, wherein the hinge device comprises a first rotation member which is connected to the first housing and rotates about a first rotational axis, and a second rotation member which is connected to the second housing and rotates about a second rotational axis. The first rotation member comprises a first engaging portion and a first seating portion, the second rotation member comprises a second engaging portion and a second seating portion, and when the housing is unfolded, the first engaging portion is located to be engaged with the second seating portion and the second engaging portion is located to be engaged with the first seating portion to act as stoppers.

## Description

### [Technical Field]

The disclosure relates to an electronic device including a hinge device.

### [Background Art]

An electronic device (e.g., portable electronic device) may include a hinge device that enables folding and unfolding of the electronic device. For example, the electronic device may include one or more housings, and the one or more housings may be rotatably connected about a folding axis via the hinge device. The housing may support a flexible display.

The hinge device may include a first rotation member that rotates about a first rotation axis and a second rotation member that rotates about a second rotation axis. The rotation members (e.g., first rotation member, second rotation member) may be connected to the housings (e.g., mechanism front) to cause the housings to rotate.

The above information may be provided as background information (related art) to aid in understanding the disclosure. None of the above is claimed to be prior art related to the disclosure, nor can it be used to determine prior art.

### [Disclosure]

### [Technical Solution]

An electronic device according to an embodiment of the disclosure may include: a housing including a first housing and a second housing; a flexible display disposed in the first housing and the second housing; and a hinge device that rotatably connects the first housing and the second housing with respect to each other.

In an embodiment, the hinge device may include a first rotation member connected to the first housing and configured to rotate about a first rotation axis, and a second rotation member connected to the second housing and configured to rotate about a second rotation axis.

In an embodiment, the first rotation member may include a first catching part and a first seating part, and the second rotation member may include a second catching part and a second seating part.

In an embodiment, when the housing is in the unfolded state, the first catching part may be positioned to interlock with the second seating part, and the second catching part may be positioned to interlock with the first seating part so as to serve as a stopper.

An electronic device according to an embodiment of the disclosure may include: a first housing; a second housing; a flexible display including a first region disposed in the first housing and a second region disposed in the second housing; and a hinge device that is configured to connect the first housing and the second housing and operate between a folded state in which the first region and the second region face each other and an unfolded state in which the first region and the second region do not face each other.

In an embodiment, the hinge device may include a first rotation member that rotates about a first rotation axis, and a second rotation member that rotates about a second rotation axis different from the first rotation axis.

In an embodiment, the first rotation member may include a first catching part and a first seating part formed at a first end facing the second rotation member in the unfolded state, and the second rotation member may include a second seating part and a second catching part formed at a second end facing the first rotation member in the unfolded state.

In an embodiment, when the first region and the second region are unfolded at a preset angle or more, the first catching part may come into contact with the second seating part.

An electronic device according to an embodiment of the disclosure may include: a housing including a first housing and a second housing; a flexible display disposed in the first housing and the second housing; and a hinge device that rotatably connects the first housing and the second housing with respect to each other.

In an embodiment, the hinge device may include a first rotation member that is connected to the first housing and rotates about a first rotation axis, and a second rotation member that is connected to the second housing and rotates about a second rotation axis different from the first rotation axis.

In an embodiment, the first rotation member may include a first catching part and a first seating part formed to protrude from the first end, and the second rotation member may include a second catching part and a second seating part formed to protrude from the second end.

In an embodiment, the first seating part may be formed at a distance from the first catching part in a direction of the first rotation axis and include a concave shape corresponding to the second catching part, and the second seating part may be formed at a distance from the second catching part in a direction of the second rotation axis and include a concave shape corresponding to the first catching part.

### [Description of Drawings]

FIG. 1 is a block diagram of an electronic device in a network environment according to an embodiment.
FIGS. 2A and 2B are views of an electronic device in an unfolded state according to an embodiment of the disclosure.
FIGS. 3A and 3B are views of an electronic device in a folded state according to an embodiment of the disclosure.
FIGS. 4A and 4B are perspective views of an electronic device according to an embodiment of the disclosure.
FIG. 5 is a view illustrating an electronic device and a hinge device according to an embodiment of the disclosure.
FIG. 6A and FIG. 6B are views illustrating a hinge device according to an embodiment of the disclosure.
FIGS. 7A and 7B are views illustrating a rotation member according to an embodiment of the disclosure.
FIGS. 8A, 8B and 8C are views illustrating a first catching part and a first seating part according to an embodiment of the disclosure.
FIG. 9 is a view illustrating a first rotation member and a second rotation member according to an embodiment of the disclosure.
FIGS. 10A, 10B and 10C are views illustrating a bracket and a rotation member according to an embodiment of the disclosure.
FIGS. 11A and 11B are views illustrating a hinge housing according to an embodiment of the disclosure.
FIGS. 12A, 12B and 12C are views illustrating a hinge device and a hinge housing according to an embodiment of the disclosure.
FIGS. 13A, 13B, 13C, 13D and 13E are views illustrating a first rotation member and a second rotation member.
FIGS. 14A and 14B are views illustrating forces acting on the first rotation member according to an embodiment of the disclosure.
FIGS. 15A and 15B are views illustrating a rotation member according to an embodiment of the disclosure.
FIGS. 16A, 16B, 16C and 16D are views illustrating a rotation member and a bracket according to an embodiment of the disclosure.
FIG. 17 is a view illustrating an electronic device according to an embodiment of the disclosure.
FIGS. 18A, 18B, 18C and 18D are views illustrating an electronic device according to an embodiment of the disclosure.

### [Mode for Disclosure]

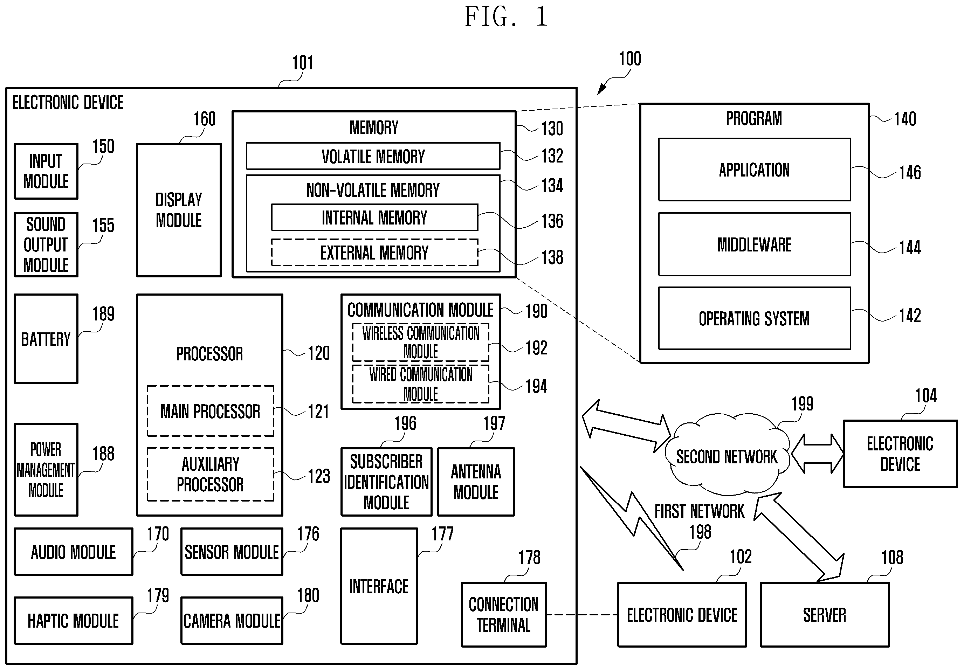

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mm Wave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

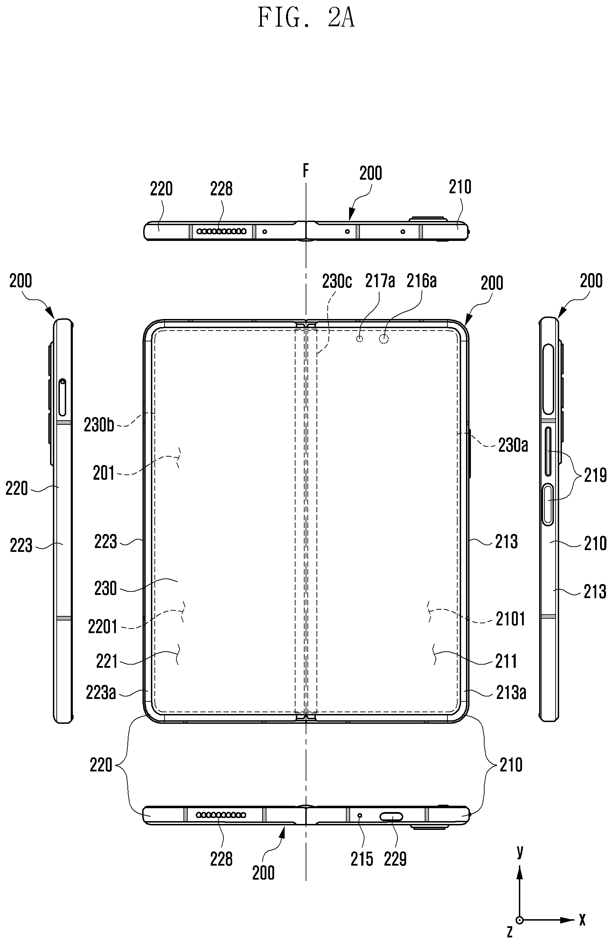

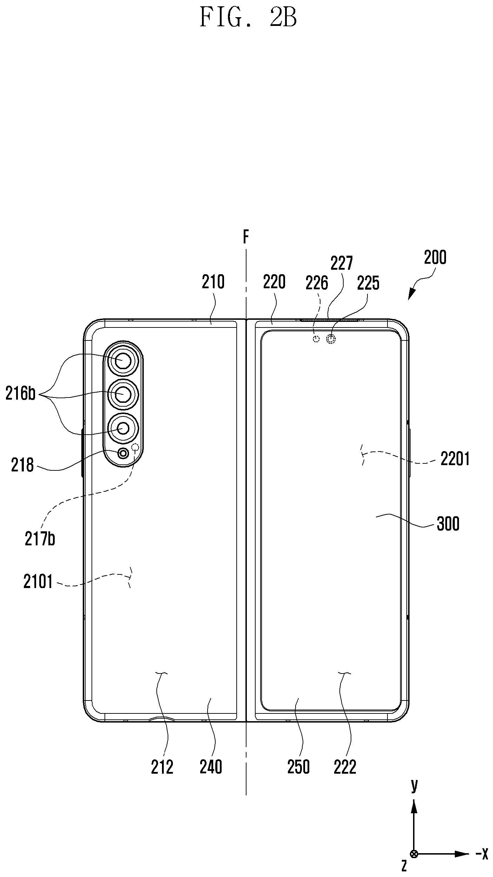

FIG. 2A is a view illustrating a front surface of an electronic device in an unfolded state according to various embodiments of the present disclosure. FIG. 2B is a view illustrating a rear surface of the electronic device in the unfolded state according to various embodiments of the present disclosure.

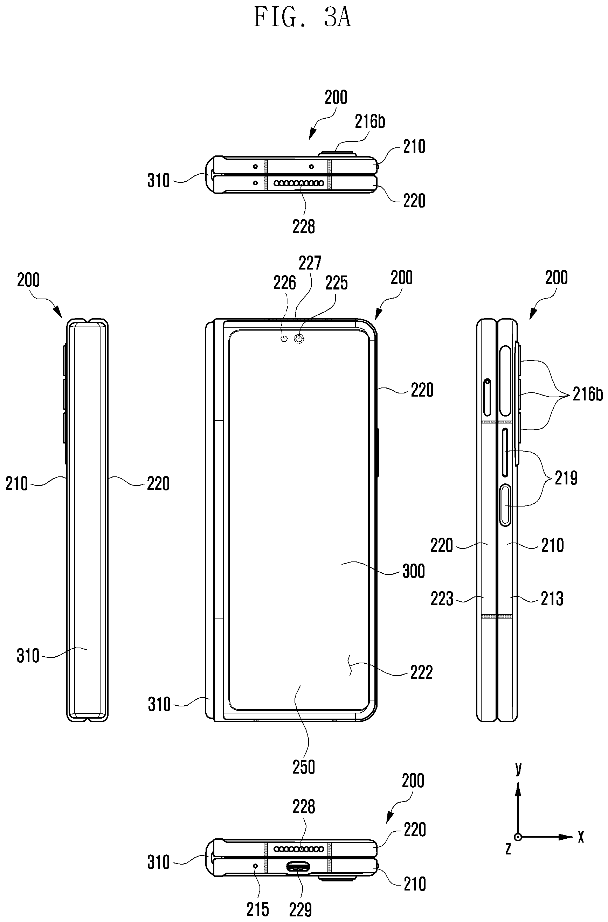

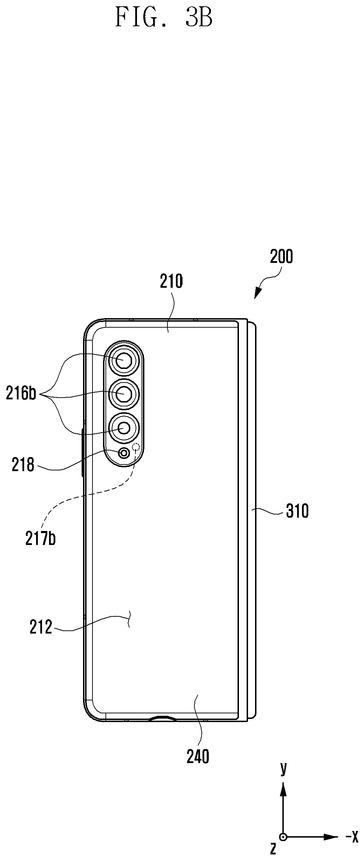

FIG. 3A is a view illustrating one side of the electronic device in a folded state according to various embodiments of the present disclosure. FIG. 3B is a view illustrating the other side of the electronic device in the folded state according to various embodiments of the present disclosure.

With reference to FIGS. 2A to 3B, an electronic device 200 may include a first housing 210 (e.g., a first housing part or a first housing structure) and a second housing 220 (e.g., a second housing part or a second housing structure) coupled to be rotatable about a folding axis F relative to each other by means of at least one of hinge modules (e.g., a hinge device or a hinge structure). In the embodiment, the first housing 210 and the second housing 220 may be configured as a housing (e.g., a foldable housing) of the electronic device 200. In the embodiment, the electronic device 200 may include a first display 230 (e.g., a flexible display, a foldable display, or a main display) disposed to be supported by being accommodated in the first and second housings. In the embodiment, the electronic device 200 may include a second display 300 (e.g., a sub-display) disposed by means of the second housing 220. In the embodiment, the electronic device 200 may include a hinge housing 310 (e.g., a hinge cover). In the unfolded state, the hinge housing 310 may be disposed to be at least partially invisible from the outside by the first housing 210 and the second housing 220. The hinge housing 310 may cover at least one of the hinge modules so that the hinge module is invisible from the outside while the electronic device 200 is in the folded state or is being folded. In the present document, a surface on which the first display 230 is disposed may be defined as a front surface of the electronic device 200, and a surface opposite to the front surface may be defined as a rear surface of the electronic device 200. In addition, a surface, which surrounds a space between the front surface and the rear surface, may be defined as a side surface of the electronic device 200.

According to various embodiments, the first housing 210 and the second housing 220 may be disposed at two opposite sides based on the folding axis F and have an entirely symmetric shape with respect to the folding axis F. The first housing 210 and the second housing 220 may be folded to be consistent with each other. According to any embodiment, the first housing 210 and the second housing 220 may be folded asymmetrically with respect to the folding axis F. In the embodiment, an angle or distance between the first housing 210 and the second housing 220 may vary depending on whether the electronic device 200 is in an unfolded state, a folded state, or an intermediate state.

According to various embodiments, the first housing 210 may include a first surface 211 connected to at least one of the hinge modules and disposed to be directed toward the front surface of the electronic device 200 in the unfolded state, a second surface 212 directed in a direction opposite to the first surface 211, and/or a first lateral member 213 configured to surround at least a part of a first space 2101 between the first surface 211 and the second surface 212. In the embodiment, the second housing 220 may include a third surface 221 connected to at least one of the hinge modules and disposed to be directed toward the front surface of the electronic device 200 in the unfolded state, a fourth surface 222 directed in a direction opposite to the third surface 221, and/or a second lateral member 223 configured to surround at least a part of a second space 2201 between the third surface 221 and the fourth surface 222. In the embodiment, the first surface 211 is directed in substantially the same direction as the third surface 221 in the unfolded state, and the first surface 211 may at least partially face the third surface 221 in the folded state. In the embodiment, the electronic device 200 may also include a recess 201 formed by structurally coupling the first housing 210 and the second housing 220 and configured to accommodate the first display 230. In the embodiment, the recess 201 may have substantially the same size as the first display 230. In the embodiment, the first housing 210 may include a first protective frame 213a (e.g., a first decorative member) coupled to the first lateral member 213, disposed to overlap an edge of the first display 230, and configured to cover the edge of the first display 230 so that the edge of the first display 230 is not visible from the outside when the first display 230 is viewed from above. In the embodiment, the first protective frame 213a may be integrated with the first lateral member 213. In the embodiment, the second housing 220 may include a second protective frame 223a (e.g., a second decorative member) coupled to the second lateral member 223, disposed to overlap an edge of the first display 230, and configured to cover the edge of the first display 230 so that the edge of the first display 230 is not visible from the outside when the first display 230 is viewed from above. In the embodiment, the second protective frame 223a may be integrated with the second lateral member 223. In any embodiment, the first protective frame 213a and the second protective frame 223a may be excluded.

According to various embodiments, the hinge housing 310 (e.g., the hinge cover) may be disposed between the first housing 210 and the second housing 220 and disposed to cover a part of at least one of the hinge modules. In the embodiment, the hinge housing 310 may be covered by a part of the first housing 210 and a part of the second housing 220 or exposed to the outside in accordance with whether the electronic device 200 is in the unfolded state, the folded state, or the intermediate state. For example, in case that the electronic device 200 is in the unfolded state, at least a part of the hinge housing 310 may be disposed to be covered by the first housing 210 and the second housing 220 so that at least a part of the hinge housing 310 is substantially invisible from the outside. In the embodiment, in case that the electronic device 200 is in the folded state, at least a part of the hinge housing 310 may be disposed between the first housing 210 and the second housing 220 so that at least a part of the hinge housing 310 is visible from the outside. In the embodiment, in the intermediate state in which the first housing 210 and the second housing 220 define a predetermined angle therebetween (are folded with a certain angle), the hinge housing 310 may be disposed between the first housing 210 and the second housing 220 so that the hinge housing 310 is at least partially visible from the outside of the electronic device 200. For example, an area of the hinge housing 310, which is exposed to the outside, may be smaller than an area of the hinge housing 310 exposed to the outside in the completely folded state. In the embodiment, the hinge housing 310 may include a curved surface.

According to various embodiments, the electronic device 200 may include at least one of at least one of displays 230 and 300 disposed in the first housing 210 and/or the second housing 220, an input device 215, sound output devices 227 and 228, sensor modules 217a, 217b, and 226, camera modules 216a, 216b, and 225, key input devices 219, an indicator (not illustrated), and a connector port 229. In any embodiment, the electronic device 200 may further include at least one of the other constituent elements. In any embodiment, at least one of the above-mentioned constituent elements may be excluded.

According to various embodiments, at least one of the displays 230 and 300 may include the first display 230 (e.g., the flexible display) disposed to be supported by the third surface 221 of the second housing 220 from the first surface 211 of the first housing 210, and the second display 300 disposed in an internal space of the second housing 220 so as to be at least partially visible from the outside through the fourth surface 222. In any embodiment, the second display 300 may also be disposed in an internal space of the first housing 210 so as to be visible from the outside through the second surface 212. In the embodiment, the first display 230 may be mainly used when the electronic device 200 is in the unfolded state, and the second display 300 may be mainly used when the electronic device 200 is in the folded state. In the embodiment, in the intermediate state, the electronic device 200 may control the first display 230 and/or the second display 300 on the basis of a folding angle between the first housing 210 and the second housing 220 so that the first display 230 and/or the second display 300 may be used.

According to various embodiments, the first display 230 may be disposed in an accommodation space defined between the pair of housings 210 and 220. For example, the first display 230 may be disposed in the recess 201 defined by the pair of housings 210 and 220 and disposed to occupy the substantially most part of the front surface of the electronic device 200 in the unfolded state. In the embodiment, the first display 230 may include a flexible display having at least a partial area that may be deformed to a flat or curved surface. In the embodiment, the first display 230 may include a first area 230a corresponding to the first housing 210, and a second area 230b corresponding to the second housing 220. In the embodiment, the first display 230 may include a folding area 230c including a part of the first area 230a and a part of the second area 230b based on the folding axis F. In the embodiment, at least a part of the folding area 230c may include an area corresponding to at least one of the hinge modules. In the embodiment, the areas of the first display 230 are merely separated exemplarily by the pair of housings 210 and 220 and at least one of the hinge modules, and the first display 230 may be substantially expressed as a single overall seamless screen defined by the pair of housings 210 and 220 and at least one of the hinge modules. In the embodiment, the first area 230a and the second area 230b may have an entirely symmetric shape or a partially asymmetric shape based on the folding area 230c and/or the folding axis F.

According to various embodiments, the electronic device 200 may include a first rear surface cover 240 disposed on the second surface 212 of the first housing 210, and a second rear surface cover 250 disposed on the fourth surface 222 of the second housing 220. In any embodiment, at least a part of the first rear surface cover 240 may be integrated with the first lateral member 213. In any embodiment, at least a part of the second rear surface cover 250 may be integrated with the second lateral member 223. In the embodiment, at least one of the first rear surface cover 240 and the second rear surface cover 250 may be provided in the form of a substantially transparent plate (e.g., a glass or polymer plate including various coating layers) or an opaque plate. In the embodiment, for example, the first rear surface cover 240 may be provided in the form of an opaque plate made of coated or tinted glass, ceramic, polymer, metal (e.g., aluminum, stainless steel (STS), or magnesium), or a combination of at least two of the above-mentioned materials. In the embodiment, for example, the second rear surface cover 250 may be provided in the form of a substantially transparent plate made of glass, polymer, or the like. Therefore, the second display 300 may be disposed in the internal space of the second housing 220 so as to be visible from the outside through the second rear surface cover 250.

According to various embodiments, the input device 215 may include a microphone. In any embodiment, the input device 215 may include a plurality of microphones disposed to detect a direction of sound. In the embodiment, the sound output devices 227 and 228 may include speakers. In the embodiment, the sound output devices 227 and 228 may include a telephone receiver 227 disposed by means of the fourth surface 222 of the second housing 220, and an external speaker 228 disposed by means of at least a part of the second lateral member 223 of the second housing 220. In any embodiment, the input device 215, the sound output devices 227 and 228, and the connector 229 may be disposed in spaces of the first housing 210 and/or the second housing 220 and exposed to an external environment through at least one hole formed in the first housing 210 and/or the second housing 220. In any embodiment, the holes formed in the first housing 210 and/or the second housing 220 may be used in common for the input device 215 and the sound output devices 227 and 228. In any embodiment, the sound output devices 227 and 228 may include speakers (e.g., piezoelectric speakers) that operate without holes formed in the first housing 210 and/or the second housing 220.

According to various embodiments, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. In the embodiment, the electronic device 200 may include a flash 218 disposed in the vicinity of the second camera module 216b. In the embodiment, for example, the flash 218 may include a light-emitting diode or a xenon lamp. In the embodiment, the camera modules 216a, 216b, and 225 may each include one lens or a plurality of lenses, an image sensor, and/or an image signal processor. In any embodiment, at least one of the camera modules 216a, 216b, and 225 may include two or more lenses (e.g., a wide-angle lens and a telephoto lens) and image sensors and be disposed together on any one surface of the first housing 210 and/or the second housing 220.

According to various embodiments, the sensor modules 217a, 217b, and 226 may generate electrical signals or data values corresponding to an internal operating state of the electronic device 200 or the external environment state. In the embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In any embodiment, the sensor modules 217a, 217b, and 226 may include at least one of a gesture sensor, a grip sensor, a color sensor, an infrared (IR) sensor, an illuminance sensor, an ultrasonic sensor, an iris recognition sensor, and a distance detection sensor (e.g., a time-of-flight (TOF) sensor or a LiDAR (light detection and ranging) sensor).

According to various embodiments, the electronic device 200 may further include at least one of the non-illustrated sensor modules, e.g., an atmospheric pressure sensor, a magnetic sensor, a biosensor, a temperature sensor, a humidity sensor, and a fingerprint recognition sensor. In any embodiment, the fingerprint recognition sensor may be disposed by means of at least one of the first lateral member 213 of the first housing 210 and/or the second lateral member 223 of the second housing 220.

According to various embodiments, the key input devices 219 may be disposed to be exposed to the outside through the first lateral member 213 of the first housing 210. In any embodiment, the key input devices 219 may be disposed to be exposed to the outside through the second lateral member 223 of the second housing 220. In any embodiment, the electronic device 200 may exclude some or all of the key input devices 219, and the excluded key input device 219 may be implemented as other types such as a soft key on at least one of the displays 230 and 300. In one embodiment, the key input device 219 may be implemented by using a pressure sensor included in at least one of the displays 230 and 300.

According to various embodiments, the connector port 229 may include a connector (e.g., a USB connector or an interface connector port module (IF module)) configured to transmit or receive power and/or data to or from an external electronic device. In any embodiment, the connector port 229 may serve to transmit or receive audio signals to or from the external electronic device or further include a separate connector port (e.g., an earphone jack hole) for transmitting or receiving audio signals to or from the external electronic device.

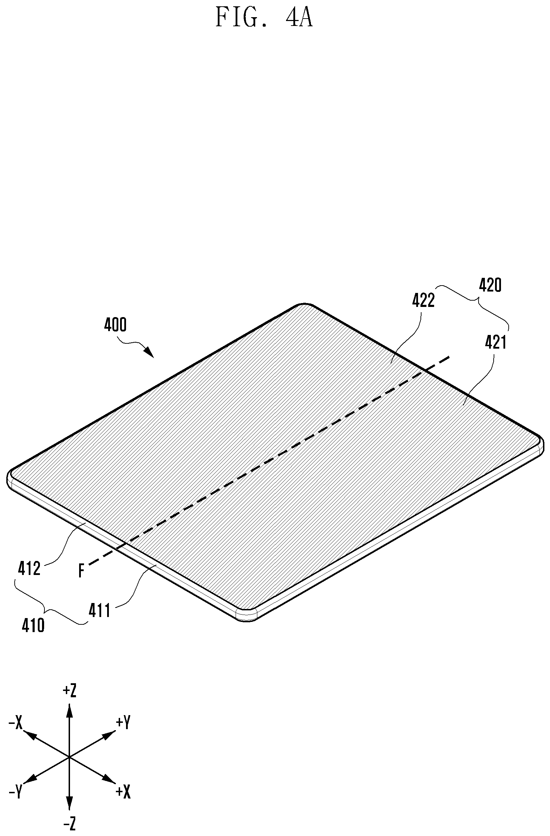

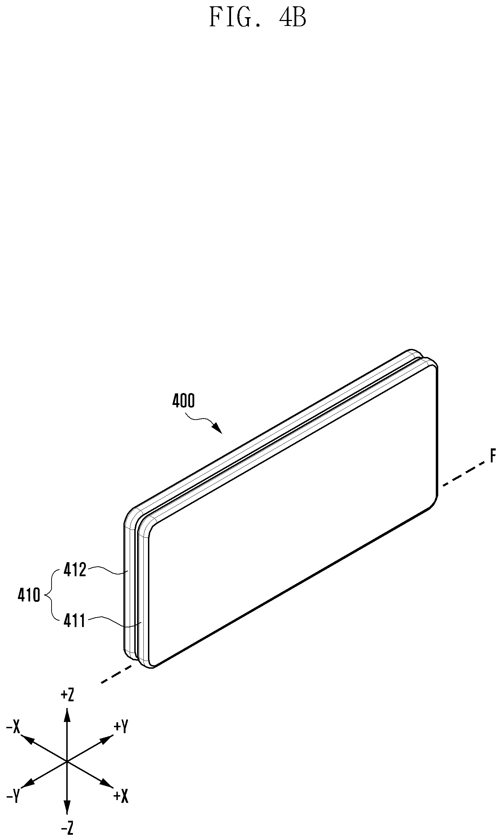

According to various embodiments, at least one of the camera modules 216a and 225 among the camera modules 216a, 216b, and 225, at least one of the sensor modules 217a and 226 among the sensor modules 217a, 217b, and 226, and/or the indicator may be disposed to be visually exposed through at least one of the displays 230 and 300. For example, at least one of the camera modules 216a and 225, at least one of the sensor modules 217a and 226, and/or the indicator may be provided in the internal space of at least one of the housings 210 and 220, disposed below an activation area (display area) of at least one of the displays 230 and 300, and disposed to adjoin the external environment through a transparent area or an opening bored to a cover member (e.g., a window layer 410 in FIG. 4 and/or the second rear surface cover 250). In the embodiment, an area, in which at least one of the displays 230 and 300 faces at least one of the camera modules 216a and 225, may be a part of the area for displaying content and defined as a transmissive area having a predetermined transmittance rate. In the embodiment, the transmissive area may be formed to have a transmittance rate within a range of about 5% to about 20%. The transmissive area may include an area that overlaps an effective area (e.g., a view angle area) of at least one of the camera modules 216a and 225 through which light, which enters an image sensor to create an image, passes. For example, the transmissive area of at least one of the displays 230 and 300 may include an area having a low arrangement density of the pixels than the periphery thereof. For example, the transmissive area may be substituted for the opening. For example, at least one of the camera modules 216a and 225 may include an under-display camera (UDC) or an under-panel camera (UPC). In one embodiment, some of the camera modules 216a and 225 or some of the sensor modules 217a and 226 may be disposed to perform the functions thereof without being visually exposed through the display. For example, an area, which faces the camera modules 216a and 225 and/or the sensor modules 217a and 226 disposed below the displays 230 and 300 (e.g., the display panels), is an under-display camera (UDC) structure that does not require the bored opening.

According to various embodiments, when the electronic device 200 is in the unfolded state (e.g., the state in FIGS. 1A and 1B), the first housing 210 and the second housing 220 may define an angle of about 180 degrees. The first area 230a, the second area 230b, and the folding area 230c of the first display 230 may be disposed on substantially the same plane and directed in the same direction (e.g., a z-axis direction). In one embodiment, in case that the electronic device 200 is in the unfolded state, the first housing 210 may be rotated by an angle of about 360 degrees relative to the second housing 220 and folded reversely so that the second surface 212 and the fourth surface 222 face each other (out-folding manner).

According to various embodiments, in case that the electronic device 200 is in the folded state (e.g., the state in FIGS. 2A and 2B), the first surface 211 of the first housing 210 and the third surface 221 of the second housing 220 may be disposed to face each other. In this case, the first area 230a and the second area 230b of the first display 230 may also be disposed to face each other while defining a narrow angle (e.g., within a range of 0 to about 10 degrees) therebetween by means of the folding area 230c. In the embodiment, at least a part of the folding area 230c may be deformed in a curved shape having a predetermined curvature. In the embodiment, in case that the electronic device 200 is in the intermediate state, the first housing 210 and the second housing 220 may be disposed at a predetermined angle (a certain angle) with respect to each other. In this case, the first area 230a and the second area 230b of the first display 230 may define an angle larger than an angle in the folded state and smaller than an angle in the unfolded state. A curvature of the folding area 230c may be smaller than a curvature in the folded state and larger than a curvature in the unfolded state. In any embodiment, the first housing 210 and the second housing 220 may define an angle by means of at least one of the hinge modules so that the first housing 210 and the second housing 220 may be stopped at a designated folding angle between the folded state and the unfolded state (free stop function). In any embodiment, the first housing 210 and the second housing 220 may operate consistently while being pressed in an unfolding direction or a folding direction based on a designated inflection angle by means of at least one of the hinge modules.

FIGS. 4A and 4B are perspective views of an electronic device 400 according to an embodiment of the disclosure.

FIG. 4A is a perspective view illustrating the electronic device 400 in unfolded state according to an embodiment. FIG. 4B is a perspective view illustrating the electronic device 400 in folded state according to an embodiment.

The electronic device 400 of FIG. 4 may indicate the electronic device 101 shown in FIG. 1, or may include at least some of the components of the electronic device 101 shown in FIG. 1.

The electronic device 400 of FIG. 4A may indicate the electronic device 200 shown in FIGS. 2A, 2B, 3A and 3B, or may include at least some of the components of the electronic device 200 shown in FIGS. 2A, 2B, 3A and 3B.

In an embodiment, the electronic device 400 may include a housing 410 and/or a display 420.

In an embodiment, the housing 410 may include a first housing 411 and/or a second housing 412.

In an embodiment, the first housing 411 and the second housing 412 may be rotatably coupled to each other about the folding axis F.

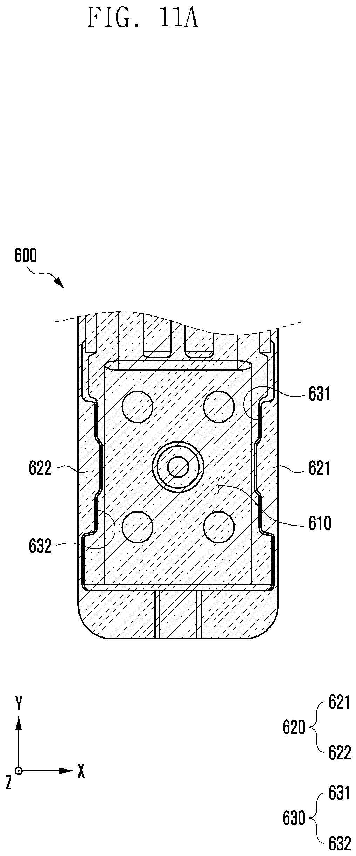

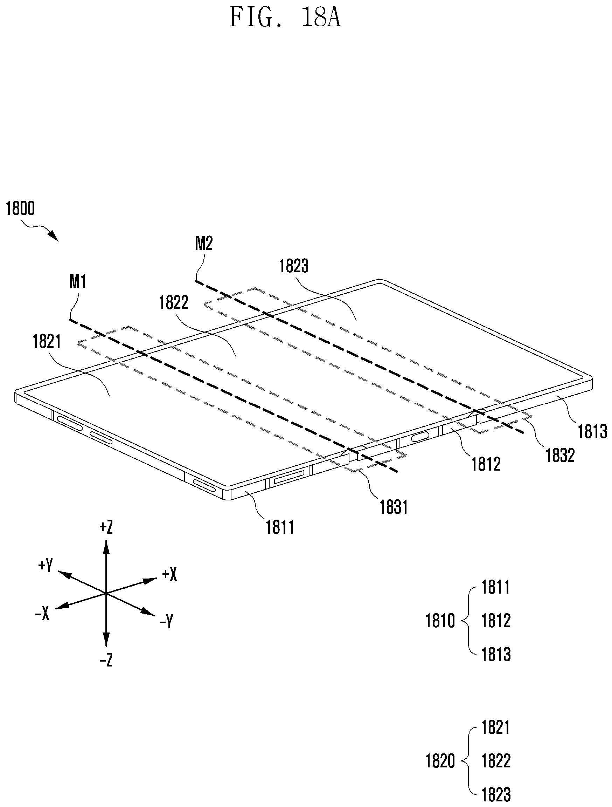

In an embodiment, the housing 410 may include other housings (e.g., hinge housing 600 in FIG. 11A, third housing 1813 in FIG. 18A) in addition to the first housing 411 and the second housing 412 shown in FIG. 4A. In an embodiment, if the housing 410 includes multiple housings, the multiple housings may be formed integrally. In an embodiment, if the housing 410 includes multiple housings, some of the multiple housings may be formed separately.

In an embodiment, the first housing 411, the second housing 412, and the hinge housing (600 in FIG. 11A) may be formed as a single housing 410. In this case, the first housing 411, the second housing 412 and the hinge housing (600 in FIG. 11A) may indicate a region of the single housing 410 formed integrally.

In an embodiment, the display 420 may be disposed to be supported by the first housing 411 and the second housing 412.

In an embodiment, the display 420 may include a flexible display whose at least a region is bendable to be deformed into a curved surface.

In an embodiment, the display 420 may include a first region 421 and/or a second region 422.

In an embodiment, the first region 421 and the second region 422 may indicate a portion of the single display 420 formed integrally.

In an embodiment, the first region 421 and the second region 422 may each indicate physically separate displays 420. For example, two physically separate displays 420 may be referred to as the first region 421 or the second region 422, respectively.

In an embodiment, the display 420 may further include other subregions in addition to the first region 421 and second region 422 shown in FIG. 4A. In an embodiment, when the display 420 includes multiple subregions, the multiple subregions may indicate one region of the single display 420 or may indicate multiple physically separate displays 420, respectively.

In an embodiment, the first region 421 of the display 420 may be disposed in the first housing 411. The second region 422 of the display 420 may be disposed in the second housing 412.

FIG. 4A may be a diagram illustrating the electronic device 400 in unfolded state. The unfolded state of the electronic device 400 may be a state in which the first region 421 and the second region 422 of the display 420 do not face each other.

In an embodiment, the unfolded state of the electronic device 400 may include a state in which the first region 421 and the second region 422 of the display 420 do not face each other and are arranged on substantially the same plane.

FIG. 4B may be a diagram illustrating the electronic device 400 in folded state. The folded state of the electronic device 400 may be a state in which the first region 421 and the second region 422 face each other.

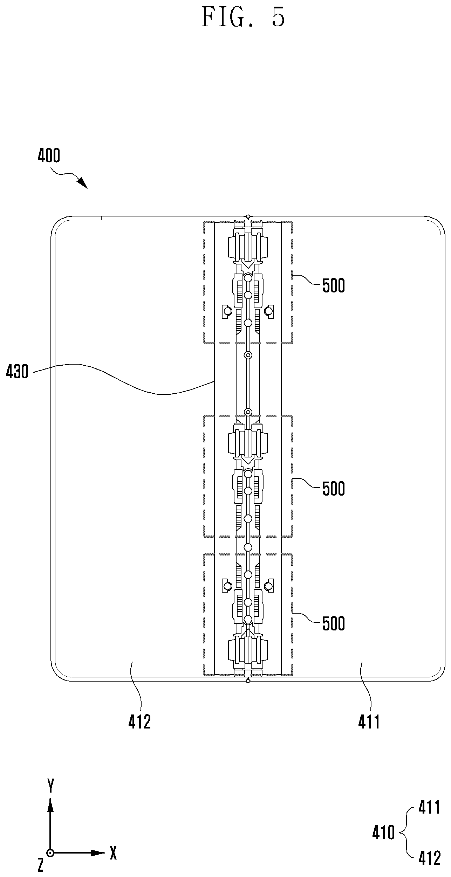

In an embodiment, the electronic device 400 may include a hinge device (500 in FIG. 5) connecting the first housing 411 and the second housing 412. For example, the hinge device (500 in FIG. 5) may rotatably connect the first housing 411 and the second housing 412.

In an embodiment, the hinge device (500 in FIG. 5) may be configured to operate between the folded state in which the first region 421 and the second region 422 face each other and the unfolded state in which the first region 421 and the second region 422 do not face each other.

FIG. 5 is a view illustrating the electronic device and the hinge device 500 according to an embodiment of the disclosure.

With reference to FIG. 5, the electronic device 400 according to an embodiment may include a hinge section 430. The hinge section 430 may rotatably connect the first housing 411 and the second housing 412.

In an embodiment, the hinge section 430 may include at least one hinge device 500. For example, with reference to FIG. 5, the hinge section 430 may include three hinge devices 500.

In an embodiment, the plural hinge devices 500 may each serve to rotatably connect the first housing 411 and the second housing 412 about the folding axis F.

In FIG. 5, the hinge section 430 of the electronic device 400 is illustrated as including three hinge devices 500, but the number of hinge devices 500 included in the hinge section 430 may be not limited thereto.

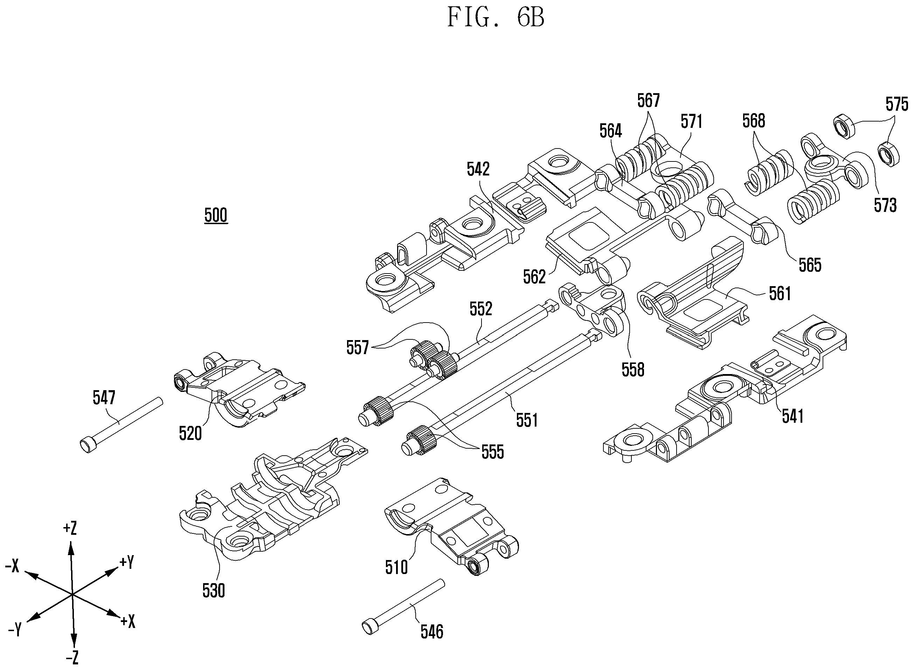

In an embodiment, some of the plural hinge devices 500 may have a different shape from the remaining hinge devices 500. For example, some hinge devices 500 may have rotation members (510 and 520 in FIG. 6B) formed in a shape different from those of other hinge devices 500.

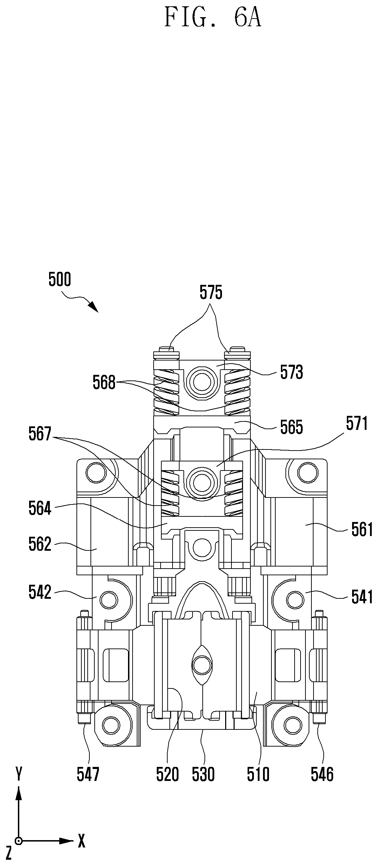

FIG. 6A and FIG. 6B are views illustrating a hinge device 500 according to an embodiment of the disclosure.

FIG. 6A is a view illustrating a hinge device 500 according to an embodiment. FIG. 6A may be an enlarged view of the hinge device 500 shown in portion A of FIG. 5. FIG. 6B is an exploded perspective view of the hinge device 500 according to an embodiment.

In describing the hinge device 500 according to an embodiment of the disclosure, the width direction of the hinge device 500 may indicate the X-axis direction, and the length direction of the hinge device 500 may indicate the Y-axis direction. The height direction of the hinge device 500 may indicate the Z-axis direction.

With reference to FIGS. 6A and 6B, the hinge device 500 according to an embodiment of the disclosure may include rotation members 510 and 520, a bracket 530, connection parts 541 and 542, connection pins 546 and 547, shafts 551 and 552, first gears 555, second gears 557, a gear bracket 558, transmission parts 561 and 562, cams 564 and 565, elastic members 567 and 568, and/or fixing members 571, 573 and 575.

In an embodiment, the rotation members 510 and 520 may include a first rotation member 510 and/or a second rotation member 520. The first rotation member 510 and the second rotation member 520 may be arranged symmetrically with respect to the folding axis (e.g., folding axis F in FIG. 4A).

In an embodiment, the rotation members 510 and 520 may serve to support the display 420 so that the display 420 may be rotated in its folding direction.

In an embodiment, the rotation members 510 and 520 may be connected with the connection parts 541 and 542 through the connection pins 546 and 547. For example, the first rotation member 510 may be connected with the first connection part 541 through the first connection pin 546. The second rotation member 520 may be connected with the second connection part 542 through the second connection pin 547.

In an embodiment, the bracket 530 may include a space where the rotation members 510 and 520 are disposed. For example, the portion of the bracket 530 on which the rotation members 510 and 520 are disposed may be formed as a curved surface so that the rotation members 510 and 520 may rotate. In an embodiment, a portion of the bracket 530 may act as a rail to support the rotation members 510 and 520 when the rotation members 510 and 520 rotate.

In an embodiment, the bracket 530 may be disposed in a hinge housing (e.g., hinge housing 600 in FIG. 11A). In an embodiment, the bracket 530 may be fixed to the hinge housing (e.g., hinge housing 600 in FIG. 11A).

In an embodiment, the connection parts 541 and 542 may be connected to the rotation members 510 and 520 and the transmission parts 561 and 562. For example, the first connection part 541 may be connected to the first rotation member 510 and the first transmission part 561. The second connection part 542 may be connected to the second rotation member 520 and the second transmission part 562.

In an embodiment, the connection parts 541 and 542 may be coupled with the housings 411 and 412 (in FIG. 4A). For example, the first connection part 541 may be coupled with the first housing 411 (in FIG. 4A). The second connection part 542 may be coupled with the second housing 412 (in FIG. 4A).

In an embodiment, the connection parts 541 and 542 may be slidably connected to the transmission parts 561 and 562. For example, the first connection part 541 may be slidably connected at least partly to the first transmission part 561. The second connection part 542 may be slidably connected at least partly to the second transmission part 562.

In an embodiment, the connection pins 546 and 547 may serve to connect the rotation members 510 and 520 and the connection parts 541 and 542 together, respectively. The rotation members 510 and 520 and the connection parts 541 and 542 may be rotated relative to the connection pins 546 and 547, respectively.

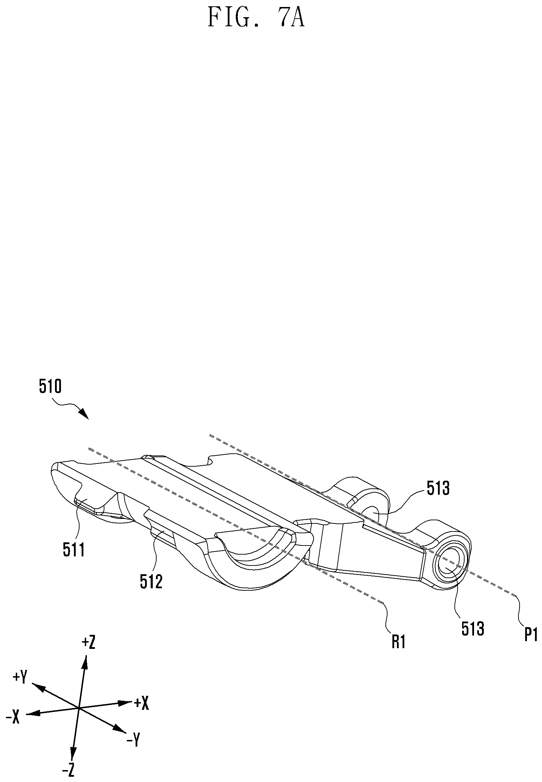

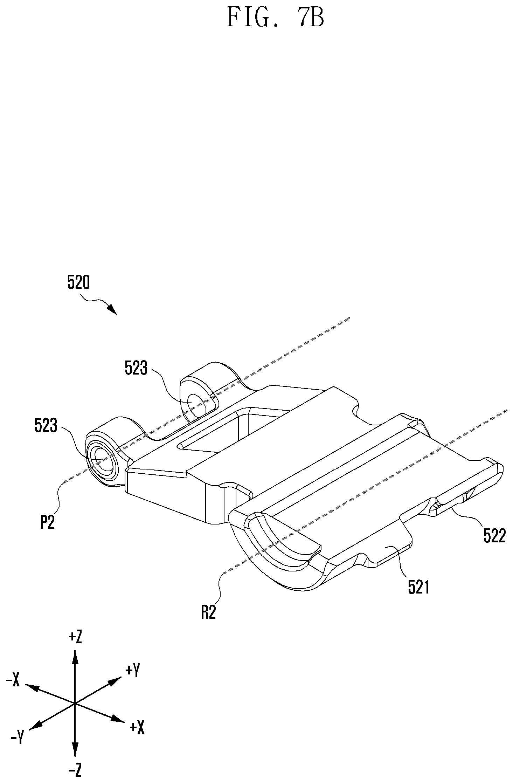

In an embodiment, the shafts 551 and 552 may be extended substantially at the same position as the rotation axes (e.g., first rotation axis R1 in FIG. 7A, second rotation axis R2 in FIG. 7B). In an embodiment, the shafts 551 and 552 may be extended in the length direction (e.g., Y-axis direction) of the hinge device 500.

In an embodiment, the shafts 551 and 552 may include a first shaft 551 and a second shaft 552.

In an embodiment, the shafts 551 and 552 may be connected to the first gears 555 and the second gears 557.

In an embodiment, the first gears 555 may be disposed at the ends of the shafts 551 and 552.

In an embodiment, the second gears 557 may enable the first shaft 551 and the second shaft 552 to interlock with each other.

In an embodiment, the gear bracket 558 may serve to fix the first gears 555 and the second gears 557 so that they can interlock at preset positions.

In an embodiment, the transmission parts 561 and 562 may be slidably connected to the connection parts 541 and 542. The transmission parts 561 and 562 may be coupled to the housing (e.g., housing 410 in FIG. 4A) to transfer motion to the housing (e.g., housing 410 in FIG. 4A). In an embodiment, the transmission parts 561 and 562 may include a cam shape.

In an embodiment, the cams 564 and 565 and the elastic members 567 and 567 may transfer resistance to the transmission parts 561 and 562. For example, during rotation of the transmission parts 561 and 562, the transmission parts 561 and 562 may receive rotational resistance from the cams 564 and 565 and the elastic members 567 and 567.

In an embodiment, the fixing members 571, 573 and 575 may serve to fix the shafts 551 and 552 and the components linked to the shafts 551 and 552.

FIGS. 7A and 7B are views illustrating the rotation members 510 and 520 according to an embodiment of the disclosure.

FIG. 7A is a perspective view of the first rotation member 510 according to an embodiment. FIG. 7B is a perspective view of the second rotation member 520 according to an embodiment.

With reference to FIG. 7A, the first rotation member 510 may include a first catching part 511, a first seating part 512, and/or a first pin opening 513.

In an embodiment, the first catching part 511 and the first seating part 512 may be formed at one end portion of the first rotation member 510.

In an embodiment, the first catching part 511 and the first seating part 512 may be formed by a portion of the first rotation member 510 protruding from one end portion of the first rotation member 510.

In an embodiment, the pin opening 513 may be formed at the other end portion opposite to the one end portion of the first rotation member 510.

In an embodiment, the first connection pin 546 (in FIG. 6B) may be inserted into the first pin opening 513. The first connection pin 546 (in FIG. 6B) may be inserted into the first pin opening 513 along the first pin axis P1.

In an embodiment, the first rotation member 510 may be rotated about the first rotation axis R1.

With reference to FIG. 7B, the second rotation member 520 may include a second catching part 521, a second seating part 522, and/or a second pin opening 523.

In an embodiment, the second catching part 521 and the second seating part 522 may be formed at one end portion of the second rotation member 520.

In an embodiment, the second catching part 521 and the second seating part 522 may be formed by a portion of the second rotation member 520 protruding from one end portion of the second rotation member 520.

In an embodiment, the second pin opening 523 may be formed at the other end portion opposite to the one end portion of the second rotation member 520.

In an embodiment, the second connection pin 547 (in FIG. 6B) may be inserted into the second pin opening 523. The second connection pin 547 (in FIG. 6B) may be inserted into the second pin opening 523 along the second pin axis P2.

In an embodiment, the second rotation member 520 may be rotated about the second rotation axis R2.

In an embodiment, the first catching part 511 and the second catching part 521 may have substantially the same shape.

In an embodiment, the first seating part 512 and the second seating part 522 may have substantially the same shape.

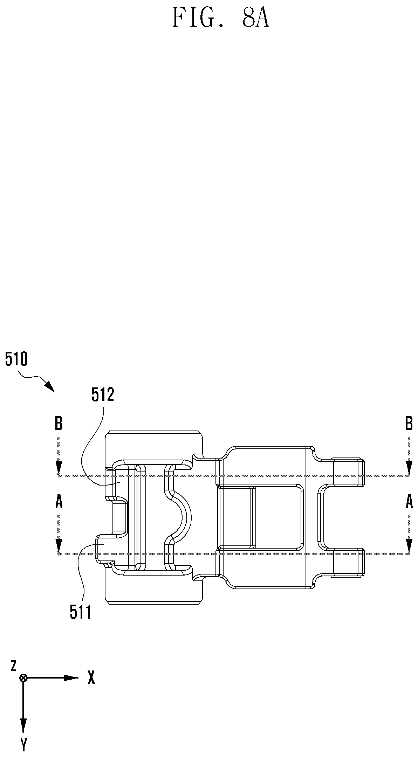

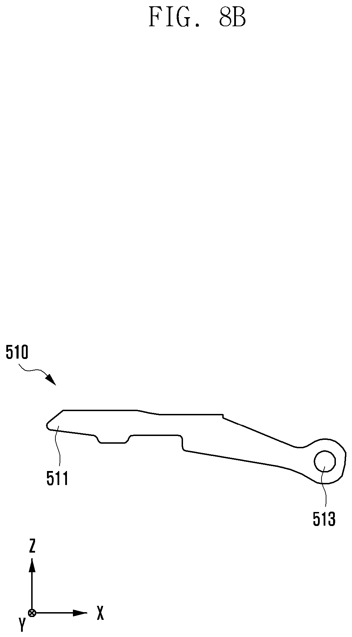

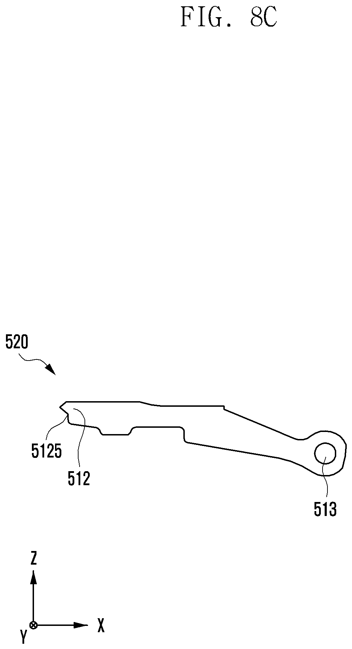

FIGS. 8A, 8B and 8C are views illustrating the first catching part 511 and the first seating part 512 according to an embodiment of the disclosure.

FIG. 8A is a top view of the first rotation member 510 according to an embodiment. FIG. 8A may be a view of the first rotation member 510 viewed along the Z-axis.

FIG. 8B is a cross-sectional view of the first rotation member 510 taken along line A-A shown in FIG. 8A. FIG. 8C is a cross-sectional view of the first rotation member 510 taken along line B-B shown in FIG. 8A.

In an embodiment, the first rotation member 510 may include a first catching part 511 and a first seating part 512.

In an embodiment, the first catching part 511 and the first seating part 512 may be formed at an end portion of the first rotation member 510. For example, the first catching part 511 and the first seating part 512 may be formed at the end portion of the first rotation member 510 facing in the negative X-axis direction.

In an embodiment, the first catching part 511 and the first seating part 512 may be disposed to be spaced apart from each other along the Y-axis direction.

With reference to FIG. 8B, the first catching part 511 may protrude compared to other regions from the end portion of the first rotation member 510.

With reference to FIG. 8C, the first seating part 512 may include a catching region 5125. The catching region 5125 may be formed by a portion of the first seating part 512 being recessed in a concave shape.

In an embodiment, the catching region 5125 may be formed by the end portion of the first seating part 512 having a ring shape.

In an embodiment, the first seating part 512 may be formed in a shape corresponding to the second catching part 521 (in FIG. 7B). For example, the catching region 5125 of the first seating part 512 may be formed in a concave shape corresponding to the second catching part 521 (in FIG. 7B).

In an embodiment, the shapes of the second catching part 521 (in FIG. 7B) and the second seating part 522 (in FIG. 7B) of the second rotation member 520 (in FIG. 7B) may be substantially the same as the shapes of the first catching part 511 and the first seating part 512 of the first rotation member 510 shown in FIGS. 8B and 8C.

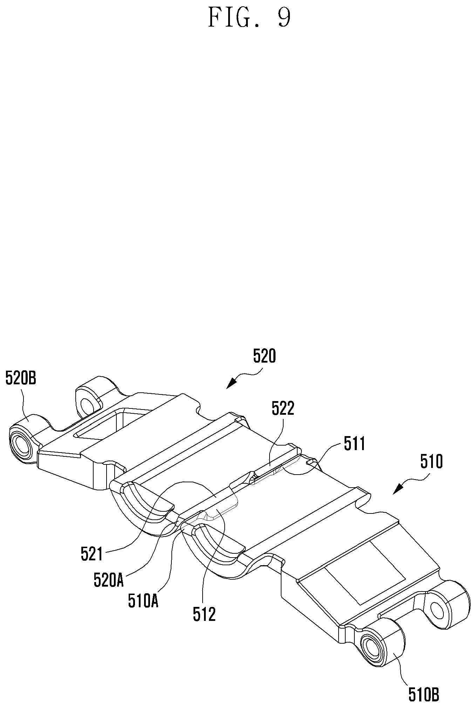

FIG. 9 is a view illustrating the first rotation member 510 and the second rotation member 520 according to an embodiment of the disclosure.

FIG. 9 may be a diagram showing the arrangement of the first rotation member 510 and the second rotation member 520 of the electronic device 400 (in FIG. 4A) in unfolded state.

In an embodiment, the unfolded state of the electronic device 400 (in FIG. 4A) may include a state in which the first housing 411 (in FIG. 4A) and the second housing 412 (in FIG. 4A) are unfolded at a preset angle (e.g., 180 degrees) or more.

In an embodiment, the unfolded state of the electronic device 400 (in FIG. 4A) may include a state in which the first region 421 (in FIG. 4A) and the second region 422 (in FIG. 4A) of the display 420 (in FIG. 4A) are unfolded at a preset angle (e.g., 180 degrees) or more.

In an embodiment, the unfolded state of the electronic device 400 (in FIG. 4A) may include a state in which the angle between one surface of the first rotation member 510 (e.g., surface of the first rotation member 510 facing the first region 421 (in FIG. 4A) of the display 420 (in FIG. 4A)) and one surface of the second rotation member 520 (e.g., surface of the second rotation member 520 facing the second region 422 (in FIG. 4A) of the display 420 (in FIG. 4A)) is greater than or equal to a preset angle (e.g., 180 degrees).

According to an embodiment, in the unfolded state of the electronic device 400 (in FIG. 4A), the first rotation member 510 and the second rotation member 520 may be disposed such that at least portions thereof face each other. For example, in the unfolded state of the electronic device 400 (in FIG. 4A), the first catching part 511 and the first seating part 512 of the first rotation member 510 may face the second rotation member 520. In the unfolded state of the electronic device 400 (in FIG. 4A), the second catching part 521 and the second seating part 522 of the second rotation member 520 may face the first rotation member 510.

According to an embodiment, in the unfolded state of the electronic device 400 (in FIG. 4A), the first catching part 511 may be disposed to face the second seating part 522.

According to an embodiment, in the unfolded state of the electronic device 400 (in FIG. 4A), the second catching part 521 may be disposed to face the first seating part 512.

In an embodiment, in the unfolded state of the electronic device 400 (in FIG. 4A), a first end 510A of the first rotation member 510 and a second end 520A of the second rotation member 520 may face each other, and a third end 510B of the first rotation member 510 and a fourth end 520B of the second rotation member 520 may face in opposite directions.

In an embodiment, in the unfolded state of the electronic device 400 (in FIG. 4A), the first catching part 511 may come into contact with the second seating part 522. As the first catching part 511 comes into contact with the second seating part 522, the first region 421 (in FIG. 4A) and the second region 422 (in FIG. 4A) can be prevented or reduced from being excessively unfolded out.

In an embodiment, in the unfolded state of the electronic device 400 (in FIG. 4A), the second catching part 521 may come into contact with the first seating part 512. As the second catching part 521 comes into contact with the first seating part 512, the first region 421 (in FIG. 4A) and the second region 422 (in FIG. 4A) can be prevented or reduced from being excessively unfolded out.

In an embodiment, the unfolded state of the electronic device 400 (in FIG. 4A) may indicate a state in which the housing 410 (in FIG. 4A) is unfolded.

In an embodiment, when the first catching part 511 is positioned to engage the second seating part 522 and the second catching part 521 is positioned to engage the first seating part 512, further rotation of the first rotation member 510 and the second rotation member 520 can be prevented or reduced.

In an embodiment, when the first catching part 511 is positioned to be caught by the second seating part 522 and the second catching part 521 is positioned to be caught by the first seating part 512, further rotation of the first rotation member 510 and the second rotation member 520 can be prevented or reduced.

In an embodiment, when the housing 410 (in FIG. 4A) is in the unfolded state, the first catching part 511 may be positioned to engage the second seating part 522, and the second catching part 521 may be positioned to engage the first seating part 512.

In an embodiment, when the housing 410 (in FIG. 4A) is in the unfolded state, the first catching part 511 may be positioned to be caught by the second seating part 522, and the second catching part 521 may be positioned to be caught by the first seating part 512.

In an embodiment, in the unfolded state of the electronic device 400 (in FIG. 4A), only one of the catching parts 511 and 521 may come into contact with the corresponding one of the seating parts 522 and 512. For example, the first catching part 511 may be in contact with the second seating part 522, or the second catching part 521 may be in contact with the first seating part 512. Alternatively, both the catching parts 511 and 521 may come into contact with the corresponding seating parts 522 and 512. For example, the first catching part 511 and the second seating part 522 may be in contact, and at the same time, the second catching part 521 and the first seating part 512 may be in contact. As one or both of the catching parts 511 and 521 come into contact with the corresponding seating parts 522 and 512, the first region 421 (in FIG. 4A) and the second region 422 (in FIG. 4A) can be prevented or reduced from being excessively unfolded out.

In an embodiment, in the unfolded state of the electronic device 400 (in FIG. 4A), one pair of catching part-seating part may first come into contact, and then the other pair of catching part-seating part may come into contact. For example, the first catching part 511 and the second seating part 522 may first come into contact to thereby prevent the first region 421 (in FIG. 4A) and the second region 422 (in FIG. 4A) from being excessively unfolded out, and when additional force is applied, the second catching part 521 and the first seating part 512 may come into contact to further prevent or reduce the first region 421 (in FIG. 4A) and the second region 422 (in FIG. 4A) from being excessively unfolded out.

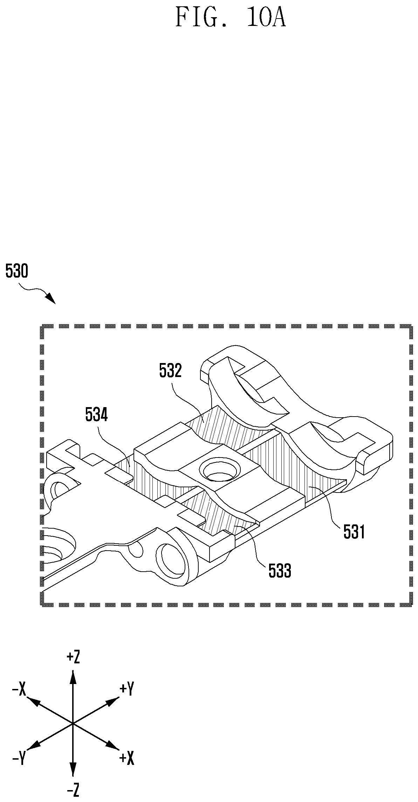

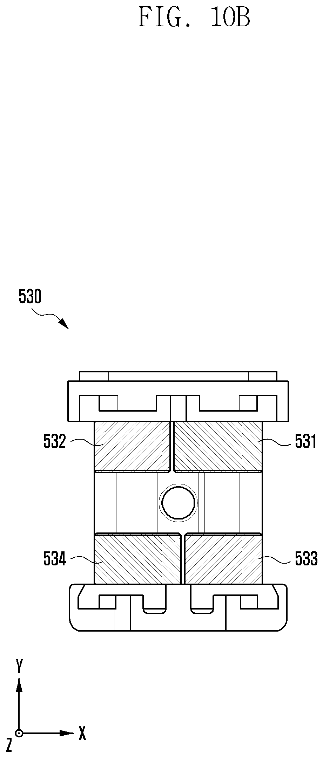

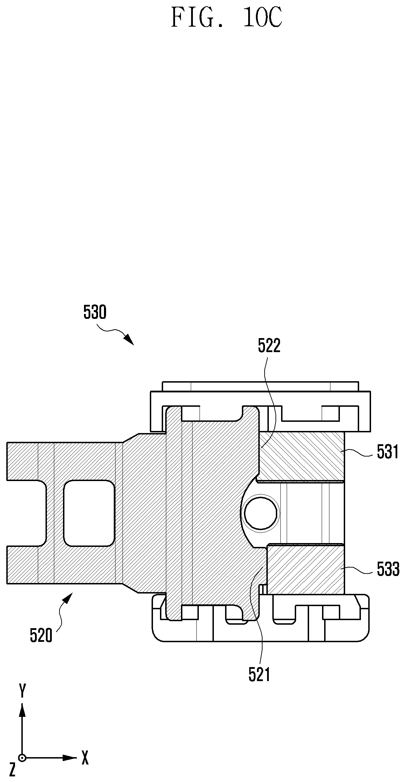

FIGS. 10A, 10B and 10C are views illustrating a bracket 530 and a rotation member 520 according to an embodiment of the disclosure.

FIG. 10A is a perspective view of the bracket 530 according to an embodiment. FIG. 10B is a top view of the bracket 530 according to an embodiment. FIG. 10C is a view of the bracket 530 with the second rotation member 520 disposed thereon according to an embodiment.

In an embodiment, the bracket 530 may serve to support the first rotation member 510 and the second rotation member 520. The first rotation member 510 and the second rotation member 520 may be disposed on the bracket 530 and be supported by the bracket 530.

In an embodiment, the bracket 530 may include a first portion 531, a second portion 532, a third portion 533, and/or a fourth portion 534.

With reference to FIGS. 10A and 10B, the second portion 532 may be formed on one side (e.g., in negative X-axis direction) of the first portion 531. The fourth portion 534 may be formed on one side (e.g., in negative X-axis direction) of the third portion 533.

In the embodiment, the portions 531, 532, 533 and 534 of the bracket 530 may be regions corresponding to two symmetrical parts of the hinge device 500 or the ends of two symmetrical parts thereof. For example, the portions 531, 532, 533 and 534 of the bracket 530 may be regions corresponding to the first rotation member 510 (in FIG. 7A) and the second rotation member 520 positioned symmetrically with the first rotation member 510 (in FIG. 7A). Alternatively, the portions 531, 532, 533 and 534 of the bracket 530 may be regions corresponding to the end of the first rotation member 510 (in FIG. 7A) and the end of the second rotation member 520 positioned symmetrically with the first rotation member 510 (in FIG. 7A).

In an embodiment, the first portion 531 of the bracket 530 may correspond to a portion of the hinge device 500 that extends to the first catching part 511 (in FIG. 7A) of the first rotation member 510 (in FIG. 7A). The first portion 531 of the bracket 530 may be formed at a position corresponding to the first catching part 511 (in FIG. 7A) of the first rotation member 510 (in FIG. 7A). For example, when the first rotation member 510 (in FIG. 7A) is disposed on the bracket 530, the first catching part 511 (in FIG. 7A) of the first rotation member 510 (in FIG. 7A) may be disposed to overlap the first portion 531 in at least some states (e.g., folded state of the electronic device 400).

In an embodiment, the second portion 532 of the bracket 530 may correspond to a portion of the hinge device 500 that extends to the second seating part 522 of the first rotation member 510. The second portion 532 of the bracket 530 may be formed at a position corresponding to the second seating part 522 of the second rotation member 520. For example, when the second rotation member 520 is disposed on the bracket 530, the second seating part 522 of the second rotation member 520 may be disposed to overlap the second portion 532 in at least some states (e.g., folded state of the electronic device 400).

In an embodiment, the third portion 533 of the bracket 530 may correspond to a portion of the hinge device 500 that extends to the first seating part 512 (in FIG. 7A) of the first rotation member 510 (in FIG. 7A). The third portion 533 of the bracket 530 may be formed at a position corresponding to the first seating part 512 (in FIG. 7A) of the first rotation member 510 (in FIG. 7A). For example, when the first rotation member 510 (in FIG. 7A) is disposed on the bracket 530, the first seating part 512 (in FIG. 7A) of the first rotation member 510 (in FIG. 7A) may be disposed to overlap the third portion 533 in at least some states (e.g., folded state of the electronic device 400).

In an embodiment, the fourth portion 534 of the bracket 530 may correspond to a portion of the hinge device 500 that extends to the second catching part 521 of the second rotation member 520. The fourth portion 534 of the bracket 530 may be formed at a position corresponding to the second catching part 521 of the second rotation member 520. For example, when the second rotation member 520 is disposed on the bracket 530, the second catching part 521 of the second rotation member 520 may be disposed to overlap the fourth portion 534 in at least some states (e.g., folded state of the electronic device 400).

With reference to FIGS. 10B and 10C, when the second rotation member 520 is disposed on the bracket 530, the second catching part 521 of the second rotation member 520 may be disposed on the fourth portion 534 of the bracket 530, and the second seating part 522 of the second rotation member 520 may be disposed on the second portion 532 of the bracket 530.

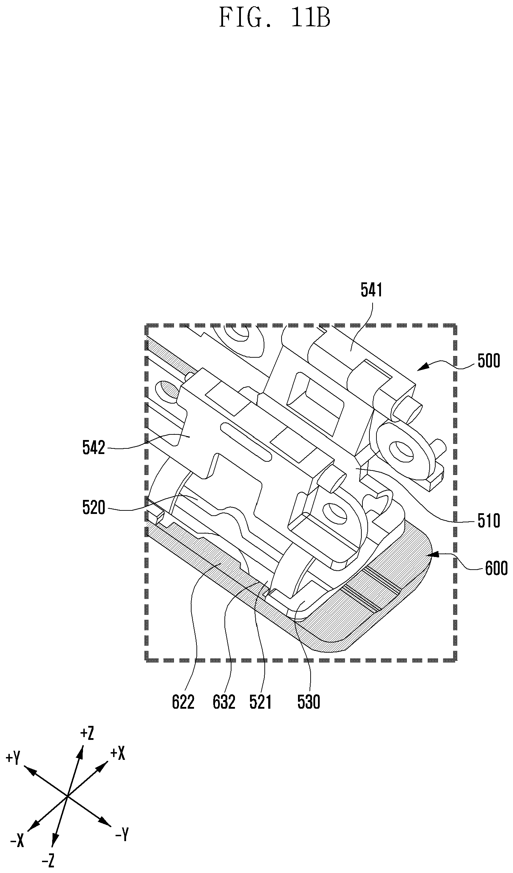

FIGS. 11A and 11B are views illustrating a hinge housing 600 according to an embodiment of the disclosure.

FIG. 11A is a view illustrating the hinge housing 600 according to an embodiment. FIG. 11B is a view illustrating the hinge device 500 disposed in the hinge housing 600 according to an embodiment.

With reference to FIG. 11A, the hinge housing 600 according to an embodiment may include a placement space 610, a side wall 620, and/or a concave part 630.

In an embodiment, the hinge housing 600 may serve to support the hinge device 500.

In an embodiment, at least a portion of the hinge device 500 may be disposed in the hinge housing 600. For example, the bracket 530 of the hinge device 500 may be disposed in the placement space 610 of the hinge housing 600.

In an embodiment, the side wall 620 may include a first side wall 621 and/or a second side wall 622. The first side wall 621 may be formed on one side (e.g., positive X-axis direction) of the placement space 610. The second side wall 622 may be formed on the other side (e.g., negative X-axis direction) of the placement space 610.

In an embodiment, the concave part 630 may include a first concave part 631 and/or a second concave part 632.

In an embodiment, a portion of the sidewall 620 of the hinge housing 600 may be concavely recessed to form the concave part 630. For example, a portion of the first side wall 621 may be concavely recessed to form the first concave part 631. A portion of the second side wall 622 may be concavely recessed to form the second concave part 632.

In an embodiment, in the folded state of the electronic device 400 (in FIG. 4B), the concave part 630 may come into contact with at least a portion of the rotation members 510 and 520.

In an embodiment, as the concave part 630 comes into contact with at least a portion of the rotation members 510 and 520, it may prevent or reduce further rotation of the rotation members 510 and 520 in a specific direction (e.g., direction in which the electronic device 400 is folded).

FIG. 11B may be a view illustrating the hinge device 500 in the folded state of the electronic device 400 (in FIG. 4B).

With reference to FIG. 11B, when the electronic device 400 (in FIG. 4B) is in the folded state, the second catching part 521 of the second rotation member 520 may come into contact with the second concave part 632. As the second catching part 521 and the second concave part 632 come into contact, the second rotation member 520 can be prevented from further rotating in the direction in which the electronic device 400 (in FIG. 4B) is folded.

In an embodiment, when the electronic device 400 (in FIG. 4B) is in the folded state, the first catching part 511 of the first rotation member 510 may come into contact with the first concave part 631. As the first catching part 511 and the first concave part 631 come into contact, the first rotation member 510 can be prevented from further rotating in the direction in which the electronic device 400 (in FIG. 4B) is folded.

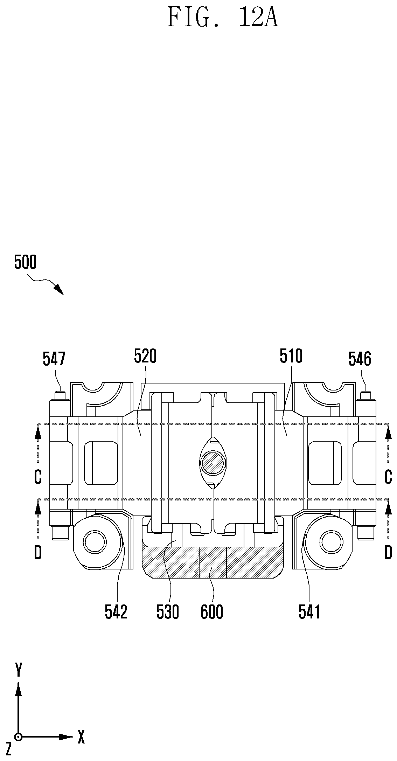

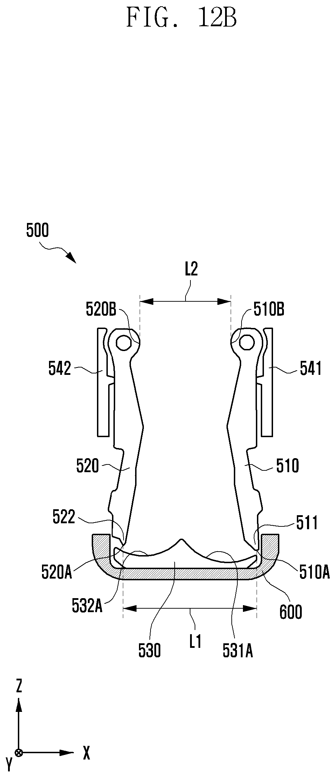

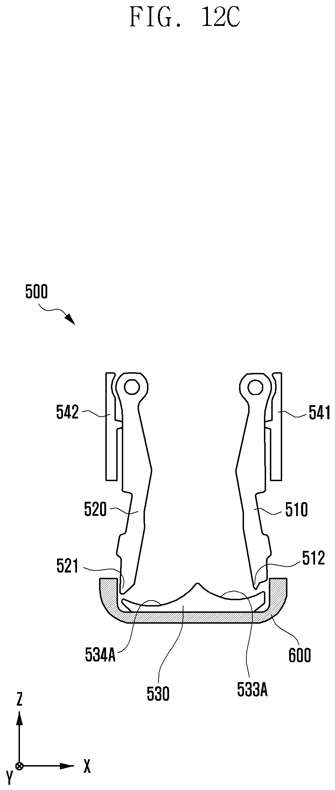

FIGS. 12A, 12B and 12C are views illustrating the hinge device 500 and the hinge housing 600 according to an embodiment of the disclosure.

FIG. 12A is a view of the hinge device 500 disposed in the hinge housing 600 according to an embodiment. FIG. 12B is a cross-sectional view of the hinge device 500 and the hinge housing 600 taken along line C-C in FIG. 12A. FIG. 12C is a cross-sectional view of the hinge device 500 and the hinge housing 600 taken along line D-D in FIG. 12B.

With reference to FIG. 12A, at least a portion of the hinge device 500 may be disposed in the hinge housing 600. For example, the bracket 530 of the hinge device 500 may be disposed in the hinge housing 600.

In an embodiment, the unfolded state of the hinge device 500 may indicate the state of the hinge device 500 when the electronic device 400 (in FIG. 4B) is in the unfolded state.

In an embodiment, the folded state of the hinge device 500 may indicate the state of the hinge device 500 when the electronic device 400 (in FIG. 4B) is in the folded state.

FIG. 12A may be a view of the hinge housing 600 and the hinge device 500 when the hinge device 500 is in the unfolded state.

FIG. 12B and FIG. 12C may be views of the hinge housing 600 and the hinge device 500 when the hinge device 500 is in the folded state.

With reference to FIG. 12B, when the hinge device 500 is in the folded state, the first rotation member 510 may be in contact with the hinge housing 600 at least partially. For example, the first catching part 511 of the first rotation member 510 may come into contact with a portion of the hinge housing 600 (e.g., first concave part 631 in FIG. 11A).

With reference to FIG. 12B, when the hinge device 500 is in the folded state, a portion of the first rotation member 510 protruding from the end thereof may come into contact with the hinge housing 600. For example, the first catching part 511 protruding from the end of the first rotation member 510 may come into contact with a portion of the hinge housing 600.

With reference to FIG. 12C, when the hinge device 500 is in the folded state, the second rotation member 520 may come into contact with the hinge housing 600 at least partially. For example, the second catching part 521 of the second rotation member 520 may come into contact with a portion of the hinge housing 600 (e.g., second concave part 632 in FIG. 11A).

With reference to FIG. 12C, when the hinge device 500 is in the folded state, a portion of the second rotation member 520 protruding from its end may contact the hinge housing 600. For example, the second catching part 521 protruding from the end of the second rotation member 520 may come into contact with a portion of the hinge housing 600.

In an embodiment, when the hinge device 500 is in the folded state, at least a portion of the rotation members 510 and 520 is in contact with the hinge housing 600, so the rotation members 510 and 520 can be prevented or reduced from further rotating in a specific direction (e.g., direction in which the electronic device 400 is folded).

In an embodiment, the first portion 531 and the second portion 532 of the bracket 530 may each include a curved surface. For example, with reference to FIG. 12B, the first portion 531 may include a first curved surface 531A. The second portion 532 may include a second curved surface 532A.

In an embodiment, the first portion 531 and the second portion 532 may have different radii of curvature. For example, with reference to FIG. 12B, the radius of curvature of the first curved surface 531A of the first portion 531 may be greater than the radius of curvature of the second curved surface 532A of the second portion 532. As the radius of curvature of the first curved surface 531A is formed relatively large, the movement of the first catching part 511 of the first rotation member 510 may be not hindered by the first curved surface 531A.

In an embodiment, since the first portion 531 and the second portion 532 have different radii of curvature, the thicknesses of portions of the bracket 530 corresponding to the first portion 531 and the second portion 532 may also be formed differently. For example, with reference to FIG. 12B, the thickness of the portion of the bracket 530 corresponding to the first portion 531 may be formed thinner than the thickness of the portion of the bracket 530 corresponding to the second portion 532.

In a certain embodiment, the first portion 531 and the second portion 532 may have substantially the same radius of curvature. For example, the radius of curvature of the first curved surface 531A of the first portion 531 may be substantially the same as the radius of curvature of the second curved surface 532A of the second portion 532.

In an embodiment, the third portion 533 and the fourth portion 534 of the bracket 530 may each include a curved surface. For example, with reference to FIG. 12C, the third portion 533 may include a third curved surface 533A. The fourth portion 534 may include a fourth curved surface 534A.

In an embodiment, the third portion 533 and the fourth portion 534 may have different radii of curvature. For example, the radius of curvature of the fourth curved surface 534A of the fourth portion 534 may be greater than the radius of curvature of the third curved surface 533A of the third portion 533. As the radius of curvature of the fourth curved surface 534A is formed relatively large, the movement of the second catching part 521 of the second rotation member 520 may be not hindered by the fourth curved surface 534A.

In an embodiment, as the third portion 533 and the fourth portion 534 have different radii of curvature, the thicknesses of portions of the bracket 530 corresponding to the third portion 533 and the fourth portion 534 may also be formed differently. For example, with reference to FIG. 12B, the thickness of the portion of the bracket 530 corresponding to the third portion 533 may be formed thicker than the thickness of the portion of the bracket 530 corresponding to the fourth portion 534.

In a certain embodiment, the third portion 533 and the fourth portion 534 may have substantially the same radius of curvature. For example, the radius of curvature of the third curved surface 533A of the third portion 533 may be substantially the same as the radius of curvature of the fourth curved surface 534A of the fourth portion 534.

In an embodiment, when the hinge device 500 is in the folded state, the first end 510A of the first rotation member 510 and the second end 520A of the second rotation member 520 may be arranged to be spaced apart by a first length L1.

In an embodiment, the third end 510B of the first rotation member 510 may be formed in a direction opposite to the first end 510A.

In an embodiment, the fourth end 520B of the second rotation member 520 may be formed in a direction opposite to the second end 520A.

In an embodiment, when the hinge device 500 is in the folded state, the third end 510B of the first rotation member 510 and the fourth end 520B of the second rotation member 520 may be arranged to be spaced apart by a second length L2 that is shorter than the first length L1. For example, the hinge device 500 of the electronic device 400 (in FIG. 4A) may be a dumbbell hinge having a dumbbell shape (or, waterdrop shape) when the hinge device 500 is viewed in a direction parallel to the length direction (e.g., in Y-axis direction) in the folded state (e.g., fully folded state) of the electronic device 400 (in FIG. 4A). If the type of the hinge device 500 is a dumbbell hinge, the first length L1 may be longer than the second length L2. If the type of the hinge device 500 is a dumbbell hinge, the difference between the first length L1 and the second length L2 may be larger compared to the case of other types of hinges (e.g., U-shaped hinge).

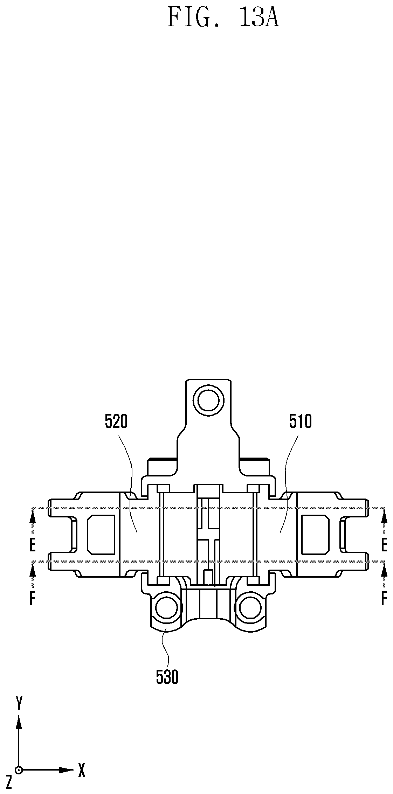

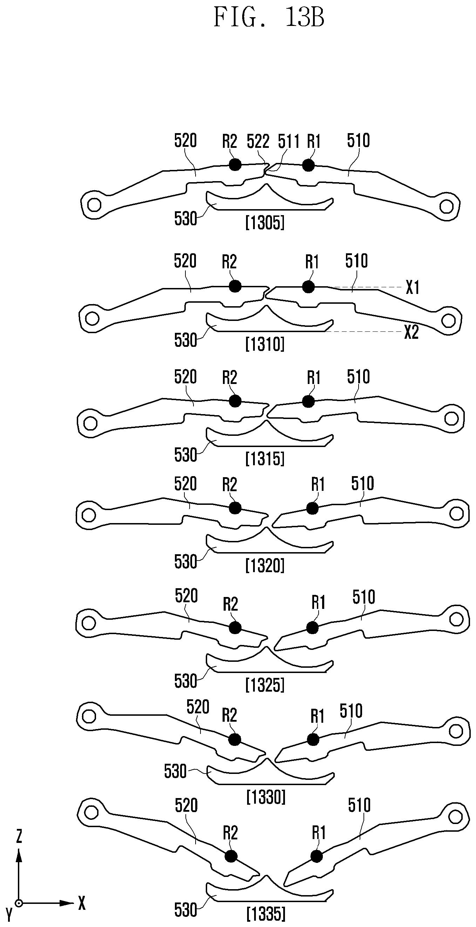

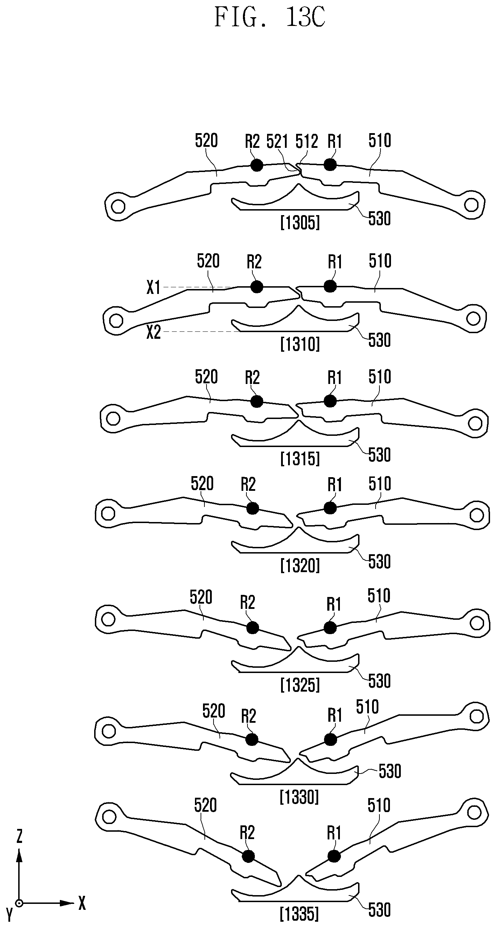

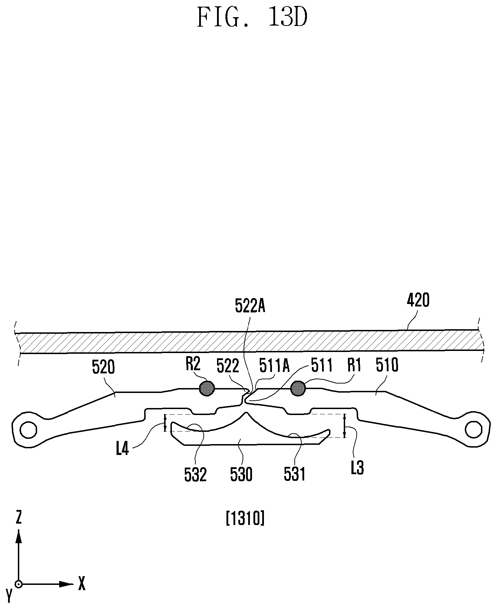

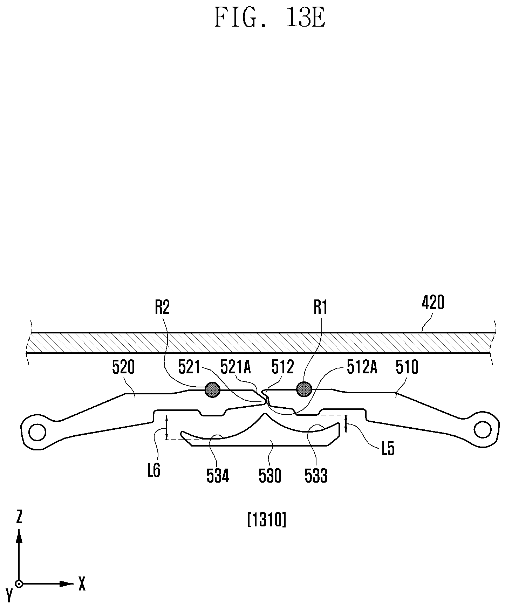

FIGS. 13A, 13B, 13C, 13D and 13E are views illustrating the first rotation member 510 and the second rotation member 520.

FIG. 13A is a view of the first rotation member 510 and the second rotation member 520 according to an embodiment.

FIG. 13B is a cross-sectional view of the first rotation member 510 and the second rotation member 520 taken along line E-E in FIG. 13A. FIG. 13C is a cross-sectional view of the first rotation member 510 and the second rotation member 520 taken along line F-F in FIG. 13A.

FIG. 13D is a view illustrating a first surface 511A of the first catching part 511 and the second surface 522A of the second seating part 522. FIG. 13E is a view illustrating a third surface 521A of the second catching part 521 and the fourth surface 512A of the first seating part 512.

FIGS. 13B and 13C may be drawings illustrating the arrangement of the first rotation member 510 and the second rotation member 520 according to the angle between the first region 421 (in FIG. 4A) and the second region 422 (in FIG. 4A) of the display 420 (in FIG. 4A) or the angle of the rotation members 510 and 520.

With reference to FIGS. 13B and 13C, in an embodiment, the angle of the rotation members 510 and 520 may indicate the angle formed by a first line X1 extending parallel to the upper portion of the rotation members 510 and 520 and a second line X2 extending parallel to the lower portion of the bracket 530.

With reference to FIGS. 13B and 13C, state 1305 may indicate a state in which the angle between the first region 421 and the second region 422 of the display 420 is greater than or equal to a preset angle (e.g., 180 degrees). Alternatively, state 1305 may indicate a state in which the angle between the first housing 411 and the second housing 412 is greater than or equal to a preset angle (e.g., 180 degrees).

In an embodiment, state 1305 may indicate a state in which portions of the two rotation members 510 and 520 are in contact with each other. For example, in state 1305, the first catching part 511 may come into contact with the second seating part 522, and the second catching part 521 may come into contact with the first seating part 512.

In an embodiment, in state 1305, the angle of the rotation members 510 and 520 may be approximately -3 degrees. For example, in state 1305, the first line X1 may be tilted by -3 degrees in the negative Z-axis direction with respect to the second line X2.

In an embodiment, state 1305 may indicate a state in which portions of the two rotation members 510 and 520 are in contact with each other to thereby prevent the two rotation members 510 and 520 from further rotating at a negative angle.

In an embodiment, state 1310 may indicate a state in which the first region 421 (in FIG. 4A) and the second region 422 (in FIG. 4A) of the display 420 (in FIG. 4A) are disposed substantially parallel to each other. In an embodiment, in state 1310, the angle of the rotation members 510 and 520 may be approximately 0 degrees. For example, the angle formed by the first line X1 extending parallel to the upper portion of the rotation members 510 and 520 and the second line X2 extending parallel to the lower portion of the bracket 530 may be approximately 0 degrees.

With reference to FIGS. 13B and 13C, in state 1310, the first rotation member 510 and the second rotation member 520 may not interfere with each other. In an embodiment, in state 1310, the first rotation member 510 and the second rotation member 520 may be spaced apart without contacting each other.

The electronic device 400 according to an embodiment may be configured so that, in state 1310, the first rotation member 510 and the second rotation member 520 do not come into contact with each other, taking manufacturing tolerances into account. The electronic device 400 according to an embodiment may be configured so that the first rotation member 510 and the second rotation member 520 are in contact with each other in a state where the angle of the rotation members 510 and 520 is less than 0 degrees (e.g., state 1305).

With reference to FIGS. 13B and 13C, state 1315 may be a state in which the first region 421 (in FIG. 4A) and the second region 422 (in FIG. 4A) of the display 420 (in FIG. 4A) are folded to be closer to each other than in state 1310. In an embodiment, in state 1315, the angle of the rotation members 510 and 520 may be approximately 6 degrees.

With reference to FIGS. 13B and 13C, state 1320 may be a state in which the first region 421 (in FIG. 4A) and the second region 422 (in FIG. 4A) of the display 420 (in FIG. 4A) are folded to be closer to each other than in state 1315. In an embodiment, in state 1320, the angle of the rotation members 510 and 520 may be approximately 12 degrees.

With reference to FIGS. 13B and 13C, state 1325 may be a state in which the first region 421 (in FIG. 4A) and the second region 422 (in FIG. 4A) of the display 420 (in FIG. 4A) are folded to be closer to each other than in state 1320. In an embodiment, in state 1325, the angle of the rotation members 510 and 520 may be approximately 18 degrees.

With reference to FIGS. 13B and 13C, state 1330 may be a state in which the first region 421 (in FIG. 4A) and the second region 422 (in FIG. 4A) of the display 420 (in FIG. 4A) are folded to be closer to each other than in state 1325. In an embodiment, in state 1330, the angle of the rotation members 510 and 520 may be approximately 24 degrees.

With reference to FIGS. 13B and 13C, state 1335 may be a state in which the first region 421 (in FIG. 4A) and the second region 422 (in FIG. 4A) of the display 420 (in FIG. 4A) are folded to be closer to each other than in state 1330. In an embodiment, in state 1335, the angle of the rotation members 510 and 520 may be approximately 30 degrees.

FIGS. 13B and 13C may be diagrams illustrating folding operations of the electronic device 400 (in FIG. 4A). For example, when the electronic device 400 (in FIG. 4A) according to an embodiment is folded, the rotation members 510 and 520 may transition from state 1305 to state 1335.

With reference to FIGS. 13B and 13C, when the electronic device 400 (in FIG. 4A) according to an embodiment is folded, the rotation members 510 and 520 may rotate about the rotation axes R1 and R2. For example, the first rotation member 510 may rotate about the first rotation axis R1. The second rotation member 520 may rotate about the second rotation axis R2.

In an embodiment, when the first region 421 (in FIG. 4A) and the second region 422 (in FIG. 4A) of the display 420 (in FIG. 4A) are unfolded more than or equal to a preset angle (e.g., 180 degrees), the first catching part 511 may come into contact with the second seating part 522. For example, with reference to FIG. 13B, in state 1305 where the first region 421 (in FIG. 4A) and the second region 422 (in FIG. 4A) of the display 420 (in FIG. 4A) are unfolded out at a preset angle or more, the first catching part 511 may come into contact with the second seating part 522.

In an embodiment, when the first region 421 (in FIG. 4A) and the second region 422 (in FIG. 4A) of the display 420 (in FIG. 4A) are unfolded more than or equal to a preset angle, the second catching part 521 may come into contact with the first seating part 512. For example, with reference to FIG. 13C, in state 1305 where the first region 421 (in FIG. 4A) and the second region 422 (in FIG. 4A) of the display 420 (in FIG. 4A) are unfolded out at a preset angle or more, the second catching part 521 may come into contact with the first seating part 512.

With reference to FIGS. 13B and 13C, in state 1305, the first rotation member 510 and the second rotation member 520 may interfere with each other. For example, the first catching part 511 of the first rotation member 510 may come into contact with the second seating part 522 of the second rotation member 520 to interfere therewith, and the second catching part 521 of the second rotation member 520 may come into contact with the first seating part 512 of the first rotation member 510 to interfere therewith.

In an embodiment, in state 1305, as the first rotation member 510 and the second rotation member 520 interfere with each other, the first rotation member 510 and the second rotation member 520 can be prevented or reduced from further rotating in the unfolding direction (e.g., in the opposite direction of the rotation from state 1305 to state 1335) compared to state 1305.

With reference to FIGS. 13B and 13C, when the first rotation member 510 and the second rotation member 520 are rotated in the folding direction (e.g., direction of the rotation from state 1305 to state 1335) with respect to state 1305, the first rotation member 510 and the second rotation member 520 may not interfere with each other. For example, with reference to states 1310 to 1335, the first rotation member 510 and the second rotation member 520 may be rotated in the folding direction, and the first catching part 511 and the second seating part 522 may become away from each other. With reference to states 1310 to 1335, the first rotation member 510 and the second rotation member 520 may be rotated in the folding direction, and the second catching part 521 and the first seating part 512 may become away from each other.

In FIGS. 13B and 13C, the first rotation member 510 and the second rotation member 520 are depicted as not contacting each other in state 1310 where the angle of the rotation members 510 and 520 is approximately 0 degrees. However, this may be illustrative only. In an embodiment, the electronic device 400 may be configured so that, unlike FIG. 13B or 13C, the first rotation member 510 and the second rotation member 520 are in contact with each other when the angle of the rotation members 510 and 520 is approximately 0 degrees (e.g., when the angle between the first region 421 (in FIG. 4A) and the second region 422 (in FIG. 4A) of the display 420 (in FIG. 4A) is approximately 180 degrees, when the angle between the first housing 411 and the second housing 412 is approximately 180 degrees). In an embodiment, when the angle of the rotation members 510 and 520 is approximately 0 degrees in the electronic device 400, the first rotation member 510 and the second rotation member 520 may come into contact with each other and interfere with each other, so further rotation of the first rotation member 510 and the second rotation member 520 in the unfolding direction can be prevented or reduced.

In an embodiment, when the electronic device 400 (in FIG. 4A) is in the unfolded state, the catching parts 511 and 521 and the corresponding seating parts 522 and 512 may be disposed to overlap each other. For example, with reference to FIGS. 13D and 13E, in the unfolded state of the electronic device 400 (in FIG. 4A), the first catching part 511 and the second seating part 522 may be disposed to at least partially overlap with each other when viewed from the display 420. In the unfolded state of the electronic device 400 (in FIG. 4A), the second catching part 521 and the first seating part 512 may be disposed to at least partially overlap each other when viewed from the display 420.

With reference to FIG. 13D, the first catching part 511 may include a first surface 511A. The first surface 511A of the first catching part 511 may face in a direction toward the display 420 (e.g., first direction).

With reference to FIG. 13D, the second seating part 522 may include a second surface 522A. The second surface 522A of the second seating part 522 may face in a direction opposite to the direction toward the display 420 (e.g., second direction).

In an embodiment, when the electronic device 400 (in FIG. 4A) is in the unfolded state, the first surface 511A of the first catching part 511 and the second surface 522A of the second seating part 522 may include an inclined shape with respect to the display 420.

In an embodiment, when the electronic device 400 (in FIG. 4A) is in the unfolded state, at least a portion of the first surface 511A and at least a portion of the second surface 522A may be disposed to overlap each other.

In an embodiment, when the display 420 is unfolded at a preset angle or more, the first surface 511A of the first catching part 511 and the second surface 522A of the second seating part 522 may be disposed to face each other. For example, when the angle between the first region 421 (in FIG. 4A) and the second region 422 (in FIG. 4A) of the display 420 is 180 degrees or more, the first surface 511A of the first catching part 511 and the second surface 522A of the second seating part 522 may be disposed to face each other.

With reference to FIG. 13E, the second catching part 521 may include a third surface 521A. The third surface 521A of the second catching part 521 may face in a direction toward the display 420 (e.g., first direction).

With reference to FIG. 13E, the first seating part 512 may include a fourth surface 512A. The fourth surface 512A of the first seating part 512 may face in a direction opposite to the direction toward the display 420 (e.g., second direction).

In an embodiment, when the electronic device 400 (in FIG. 4A) is in the unfolded state, the third surface 521A of the second catching part 521 and the fourth surface 512A of the first seating part 512 may include an inclined shape with respect to the display 420.

In an embodiment, when the electronic device 400 (in FIG. 4A) is in the unfolded state, at least a portion of the third surface 521A and at least a portion of the fourth surface 512A may be disposed to overlap each other.

In an embodiment, when the display 420 is unfolded at a preset angle or more, the third surface 521A of the second catching part 521 and the fourth surface 512A of the first seating part 512 may be disposed to face each other. For example, when the angle between the first region 421 (in FIG. 4A) and the second region 422 (in FIG. 4A) of the display 420 is 180 degrees or more, the third surface 521A of the second catching part 521 and the fourth surface 512A of the first seating part 512 may be disposed to face each other.

In an embodiment, when the angle between the first region 421 (in FIG. 4A) and the second region 422 (in FIG. 4A) of the display 420 is 180 degrees or more, or when the angle between the first rotation member 510 and the second rotation member 520 is 180 degrees or more, the ends of the catching parts 511 and 521 and the dented portions of the corresponding seating parts 522 and 512 may push against each other, so that the first rotation member 510 and the second rotation member 520 may no longer rotate.

In an embodiment, when the catching parts 511 and 521 and the corresponding seating parts 522 and 512 are in contact, the angle between the first region 421 (in FIG. 4A) and the second region 422 (in FIG. 4A) of the display 420 may be formed to be approximately 175 to 185 degrees.

In an embodiment, when the electronic device 400 (in FIG. 4A) is in the unfolded state, the distance between the first rotation member 510 and the bracket 530 may be formed differently from the distance between the second rotation member 520 and the bracket 530.

With reference to FIG. 13D, the distance between the first rotation member 510 and the first portion 531 of the bracket 530 may have a third length L3, and the distance between the second rotation member 520 and the second portion 532 of the bracket 530 may have a fourth length L4 shorter than the third length L3.

With reference to FIG. 13E, the distance between the first rotation member 510 and the third portion 533 of the bracket 530 may have a fifth length L5. The distance between the second rotation member 520 and the fourth portion 534 of the bracket 530 may have a sixth length L6 longer than the fifth length L5.

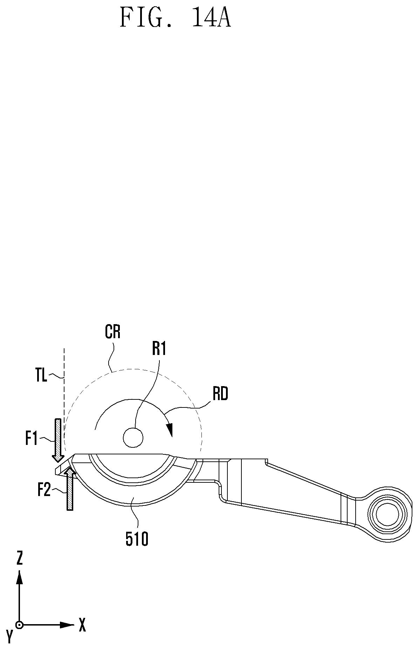

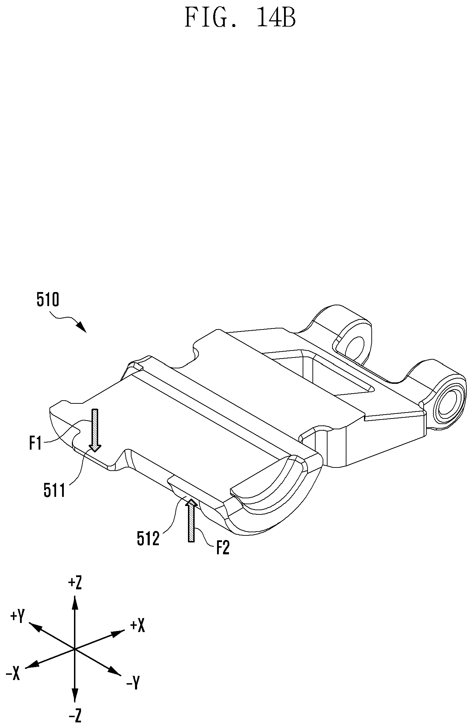

FIGS. 14A and 14B are views illustrating forces acting on the first rotation member 510 according to an embodiment of the disclosure.

FIG. 14A and FIG. 14B may be views illustrating forces acting on the first rotation member 510 when the first rotation member 510 and the second rotation member 520 (in FIG. 7B) are in contact.

In an embodiment, when the first rotation member 510 and the second rotation member 520 (in FIG. 7B) are in contact, if the first rotation member 510 is further rotated along the rotation direction RD, a first force F1 and/or a second force F2 may be applied to the first rotation member 510.

In an embodiment, the first force F1 may be a force acting on the first catching part 511 of the first rotation member 510.

In an embodiment, the second force F2 may be a force acting on the first seating part 512 of the first rotation member 510.

In an embodiment, the first force F1 and the second force F2 may act in opposite directions. For example, the first force F1 may act in a negative Z-axis direction, and the second force F2 may act in a positive Z-axis direction.

In an embodiment, the first force F1 may be distributed by the area of the first catching part 511. The second force F2 may be distributed by the area of the first seating part 512.

In an embodiment, the first force F1 may be applied to the first catching part 511 in a direction substantially parallel to the tangent line TL of the rotation orbit CR of the first catching part 511 about the first rotation axis R1. The second force F2 may be applied to the first seating part 512 in a direction substantially parallel to the tangent line TL of the rotation orbit CR of the first seating part 512 about the first rotation axis R1.

In an embodiment, as the first force F1 and the second force F2 act in the direction of the tangent line TL of the rotation orbit CR of the first catching part 511 and the first seating part 512, the deviation of the first rotation member 510 from the first rotation axis R1 during rotation can be prevented or reduced.

Although the first force F1 and the second force F2 are described in relation to the first rotation member 510 in FIGS. 14A and 14B, substantially the same description can be applied to the second rotation member 520 (in FIG. 7B).

In an embodiment, a force having the same magnitude as the first force F1 may be applied in a direction opposite to the first force F1 to the second seating part 522 (in FIG. 7B) of the second rotation member 520 (in FIG. 7B) contacting the first catching part 511.

In an embodiment, a force having the same magnitude as the second force F2 may be applied in a direction opposite to the second force F2 to the first catching part 511 (in FIG. 7B) of the second rotation member 520 (in FIG. 7B) contacting the first seating part 512.

In an embodiment, a force corresponding to the first force F1 and acting on the second rotation member 520 (in FIG. 7B) may be applied to the second seating part 522 (in FIG. 7B) in a direction substantially parallel to the tangent line (not shown) of the rotation orbit (not shown) of the second seating part 522 (in FIG. 7B) about the second rotation axis (not shown).

In an embodiment, a force corresponding to the second force F2 and acting on the second rotation member 520 (in FIG. 7B) may be applied to the second catching part 521 (in FIG. 7B) in a direction substantially parallel to the tangent line (not shown) of the rotation orbit (not shown) of the second catching part 521 (in FIG. 7B) about the second rotation axis (not shown).

In an embodiment, as the forces corresponding to the first force F1 and the second force F2 act in a direction parallel to the tangent lines (not shown) of the rotation orbits (not shown) of the second seating part 522 (in FIG. 7B) and the second catching part 521 (in FIG. 7B), the deviation of the second rotation member 520 (in FIG. 7B) from the second rotation axis (not shown) during rotation can be prevented or reduced.

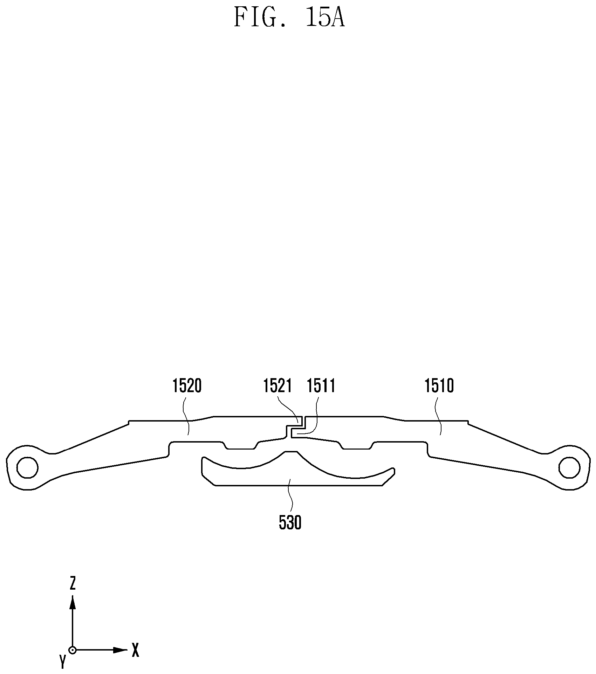

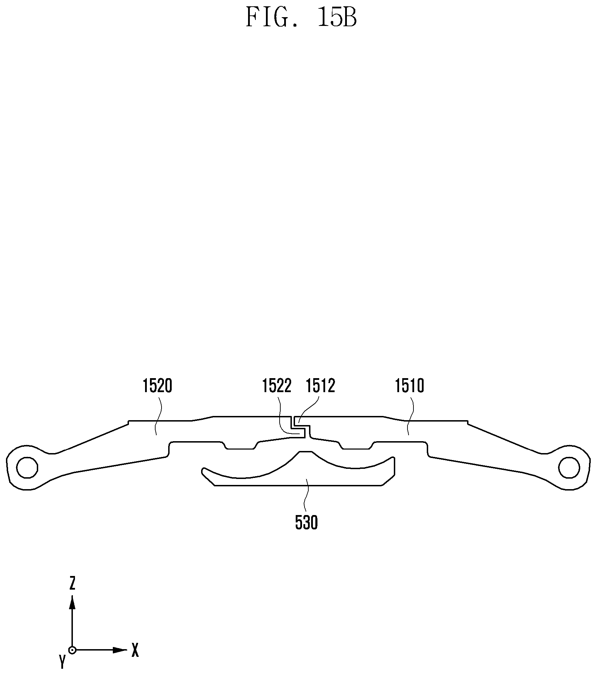

FIGS. 15A and 15B are views illustrating the rotation members 1510 and 1520 according to an embodiment of the disclosure.

FIG. 15A is a view illustrating a first protrusion 1511 and a second protrusion 1521 according to an embodiment. FIG. 15B is a view illustrating a third protrusion 1512 and a fourth protrusion 1522 according to an embodiment.

FIG. 15B may be a view illustrating the rotation members 1510 and 1520 in a different cross-section from FIG. 15A.

In an embodiment, the first rotation member 1510 may include a first protrusion 1511 and/or a third protrusion 1512.

In an embodiment, the first protrusion 1511 and the third protrusion 1512 may be formed to protrude from the end portion of the first rotation member 1510.

In an embodiment, the second rotation member 1520 may include a second protrusion 1521 and/or a fourth protrusion 1522.

In an embodiment, the second protrusion 1521 and the fourth protrusion 1522 may be formed to protrude from the end portion of the second rotation member 1520.

With reference to FIG. 15A, when the first region 421 (in FIG. 4A) and the second region 422 (in FIG. 4A) of the display 420 (in FIG. 4A) are unfolded at a preset angle (e.g., 180 degrees) or more, the first protrusion 1511 and the second protrusion 1521 may come into contact and exert force on each other.

With reference to FIG. 15B, when the first region 421 (in FIG. 4A) and the second region 422 (in FIG. 4A) of the display 420 (in FIG. 4A) are unfolded at a preset angle (e.g., 180 degrees) or more, the third protrusion 1512 and the fourth protrusion 1522 may come into contact and exert force on each other.

In an embodiment, when the first region 421 (in FIG. 4A) and the second region 422 (in FIG. 4A) of the display 420 (in FIG. 4A) are unfolded at a preset angle (e.g., 180 degrees) or more, a force is applied between the protrusions 1511 and 1512 of the first rotation member 1510 and the protrusions 1521 and 1522 of the second rotation member 1520, so the first region 421 (in FIG. 4A) and the second region 422 (in FIG. 4A) of the display 420 (in FIG. 4A) can be prevented or reduced from further rotating away from each other.

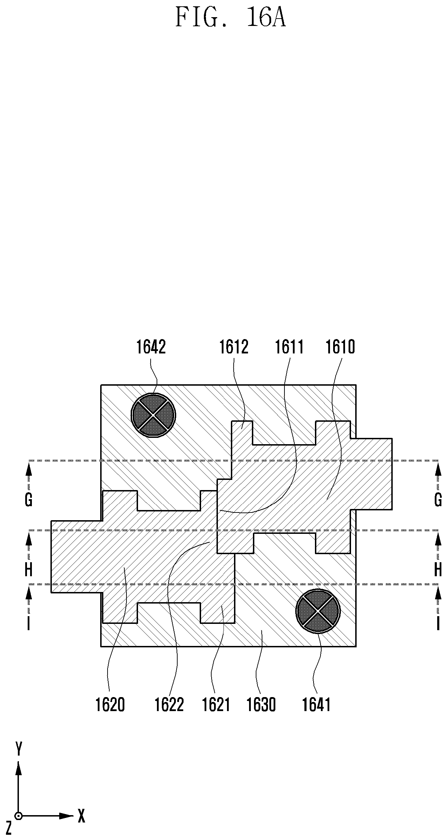

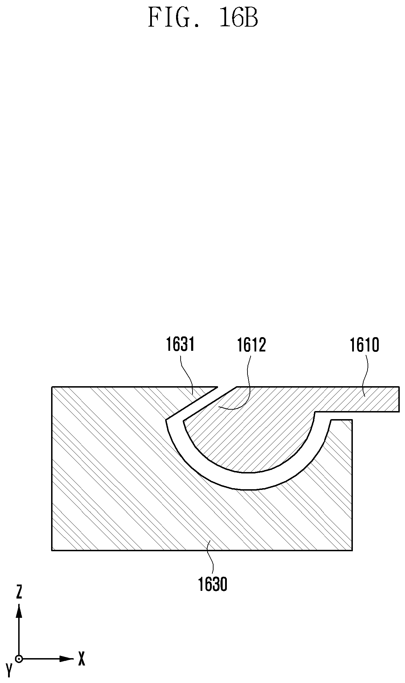

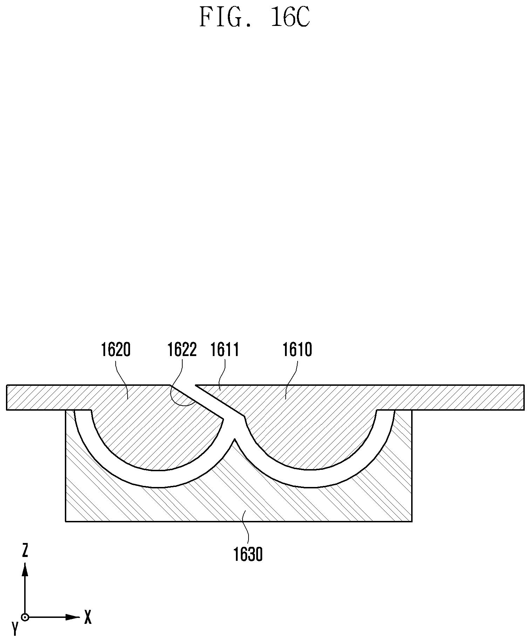

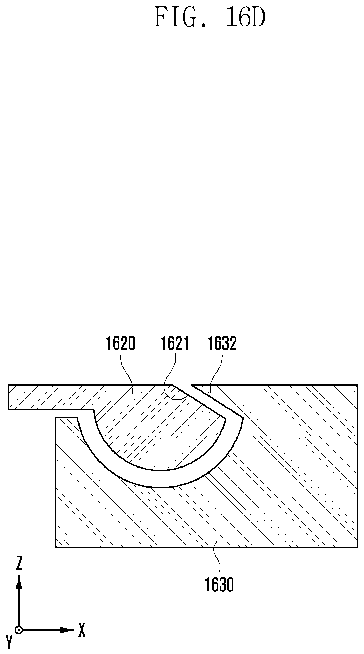

FIGS. 16A, 16B, 16C and 16D are views illustrating rotation members 1610 and 1620 and a bracket 1630 according to an embodiment of the disclosure.

FIG. 16A is a view showing rotation members 1610 and 1620 and a bracket 1630 according to an embodiment.

FIG. 16B is a cross-sectional view of the first rotation member 1610 and the bracket 1630 taken along line G-G in FIG. 16A. FIG. 16C is a cross-sectional view of the rotation members 1610 and 1620 and the bracket 1630 taken along line H-H in FIG. 16A. FIG. 16D is a cross-sectional view of the second rotation member 1620 and the bracket 1630 taken along line I-I in FIG. 16A.

In an embodiment, the bracket 1630 may include a first support part 1631 and/or a second support part 1632.

In an embodiment, the bracket 1630 may be coupled to another configuration (e.g., hinge housing 600 in FIG. 11A) through a first coupling member 1641 and/or a second coupling member 1642.

In an embodiment, the first rotation member 1610 may include a first catching part 1611 and/or a first seating part 1612.

In an embodiment, the second rotation member 1620 may include a second catching part 1621 and/or a second seating part 1622.

In an embodiment, the second catching part 1621 and the second seating part 1622 may be formed in substantially the same shape.

In an embodiment, the first seating part 1612 of the first rotation member 1610 may be formed at a position that does not overlap with the second rotation member 1620.

In an embodiment, the second catching part 1621 of the second rotation member 1620 may be formed at a position that does not overlap with the first rotation member 1610.

With reference to FIG. 16B, when the first region 421 (in FIG. 4A) and the second region 422 (in FIG. 4A) of the display 420 (in FIG. 4A) are unfolded at a preset angle (e.g., 180 degrees) or more, the first seating part 1612 may come into contact with the first support part 1631.

With reference to FIG. 16D, when the first region 421 (in FIG. 4A) and the second region 422 (in FIG. 4A) of the display 420 (in FIG. 4A) are unfolded at a preset angle (e.g., 180 degrees) or more, the first catching part 1611 may come into contact with the second seating part 1622.

With reference to FIG. 16D, when the first region 421 (in FIG. 4A) and the second region 422 (in FIG. 4A) of the display 420 (in FIG. 4A) are unfolded at a preset angle (e.g., 180 degrees) or more, the second catching part 1621 may come into contact with the second support part 1632.

In an embodiment, when the first region 421 (in FIG. 4A) and the second region 422 (in FIG. 4A) of the display 420 (in FIG. 4A) are unfolded at a preset angle (e.g., 180 degrees) or more, the first support part 1631 and the second support part 1632 may come into contact with portions of the first rotation member 1610 and the second rotation member 1620 and may serve to prevent further rotation of the first rotation member 1610 and the second rotation member 1620.

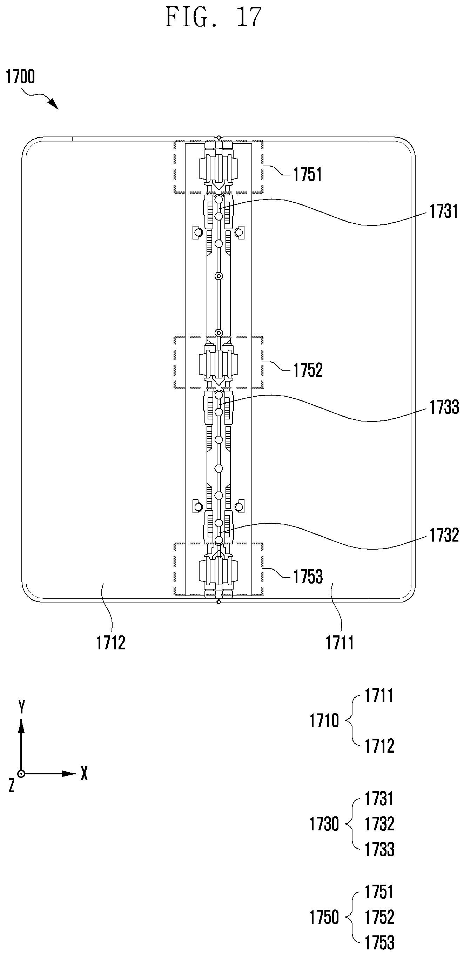

FIG. 17 is a view of an electronic device 1700 according to an embodiment of the disclosure.

The electronic device 1700 according to an embodiment of the disclosure may include a housing 1710 and/or a hinge section 1730.

In an embodiment, the hinge section 1730 may include a first hinge device 1731, a second hinge device 1732, and/or a third hinge device 1733.

In an embodiment, the hinge section 1730 may include at least one rotation unit 1750.

In an embodiment, the rotation unit 1750 may include a first rotation unit 1751, a second rotation unit 1752, and/or a third rotation unit 1753.

In an embodiment, the first hinge device 1731 may include the first rotation unit 1751. The second hinge device 1732 may include the second rotation unit 1752. The third hinge device 1733 may include the third rotation unit 1753.

In an embodiment, the first rotation unit 1751, the second rotation unit 1752, and the third rotation unit 1753 may each include two rotation members (e.g., first rotation member 510 in FIG. 9, second rotation member 520 in FIG. 9).

In an embodiment, the first rotation unit 1751, the second rotation unit 1752, and the third rotation unit 1753 may each be configured such that each rotation member (e.g., first rotation member 510 in FIG. 9, second rotation member 520 in FIG. 9) includes an catching part (e.g., first catching part 511 in FIG. 9) and a seating part (e.g., first seating part 512 in FIG. 9).

In an embodiment, the rotation members may be formed differently depending on the position of the rotation unit 1750. For example, in an embodiment, the rotation member (e.g., first rotation member 510 in FIG. 7A) of the first rotation unit 1751 or the third rotation unit 1753 may be formed to include an catching part (e.g., first catching part 511 in FIG. 7A) and a seating part (e.g., first seating part 512 in FIG. 7A); the rotation member (e.g., first rotation member 510 in FIG. 7A) of the second rotation unit 1752 may be formed not to include an catching part (e.g., first catching part 511 in FIG. 7A) or a seating part (e.g., first seating part 512 in FIG. 7A). In an embodiment, the rotation member (e.g., the first rotation member (510) of FIG. 7A) of the second rotation unit 1752 may be formed to include an catching part (e.g., first catching part 511 in FIG. 7A) and a seating part (e.g., first seating part 512 in FIG. 7A); the rotation member (e.g., first rotation member 510 in FIG. 7A) of the first rotation unit 1751 or the third rotation unit 1753 may be formed not to include an catching part (e.g., first catching part 511 in FIG. 7A) or a seating part (e.g., first seating part 512 in FIG. 7A).

In an embodiment, the second rotation unit 1752 may be configured such that one rotation member (e.g., first rotation member 510 in FIG. 7A) includes either an catching part (e.g., first catching part 511 in FIG. 7A ) or a seating part (e.g., first seating part 512 in FIG. 7A) in this order, and the other rotation member (e.g., second rotation member 520 in FIG. 7B) includes either a seating part (e.g., first seating part 512 in FIG. 7A) or an catching part (e.g., first catching part 511 in FIG. 7A) in this order. In a certain embodiment, the rotation member (e.g., first rotation member 510 in FIG. 7A) of the second rotation unit 1752 may not include an catching part (e.g., first catching part 511 in FIG. 7A) or a seating part (e.g., first seating part 512 in FIG. 7A).

In an embodiment, the number of protrusions (e.g., first catching part 511 in FIG. 7A, first seating part 512 in FIG. 7A) formed on the rotation member (e.g., rotation member 510 in FIG. 7A) of the rotation unit 1750 may be two. In a certain embodiment, the number of protrusions (e.g., first catching part 511 in FIG. 7A, first seating part 512 in FIG. 7A) formed on the rotation member (e.g., rotation member 510 in FIG. 7A) of the rotation unit 1750 may be one or three.

In an embodiment, the number of catching parts (e.g., first catching part 511 in FIG. 7A) and/or seating parts (e.g., first seating part 512 in FIG. 7A) formed on the rotation member (e.g., rotation member 510 in FIG. 7A) of the rotation unit 1750 may be different in at least some rotation units 1750 among the multiple rotation units 1750.

In an embodiment, the number of protrusions (e.g., first catching part 511 in FIG. 7A, first seating part 512 in FIG. 7A) formed on the rotation member (e.g., rotation member 510 in FIG. 7A) of the rotation unit 1750 may vary depending on the length of the hinge device 1731, 1732 or 1733, the position at which the rotation member (e.g., rotation member 510 in FIG. 7A) is disposed, and the specific components of the electronic device 1700.

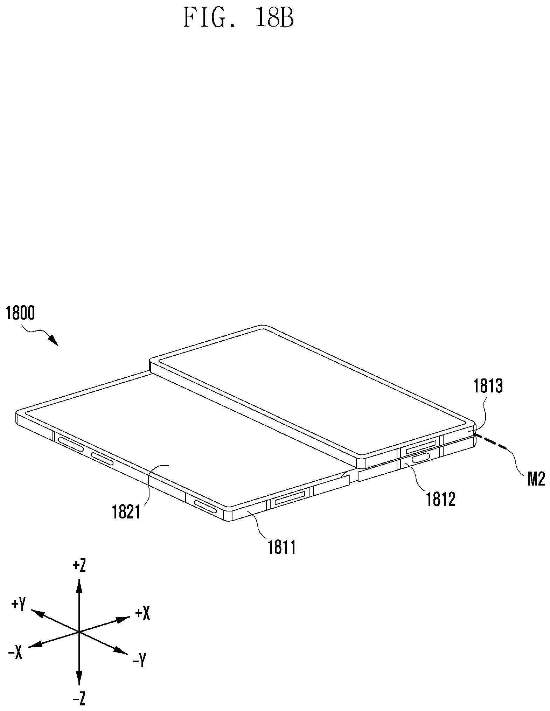

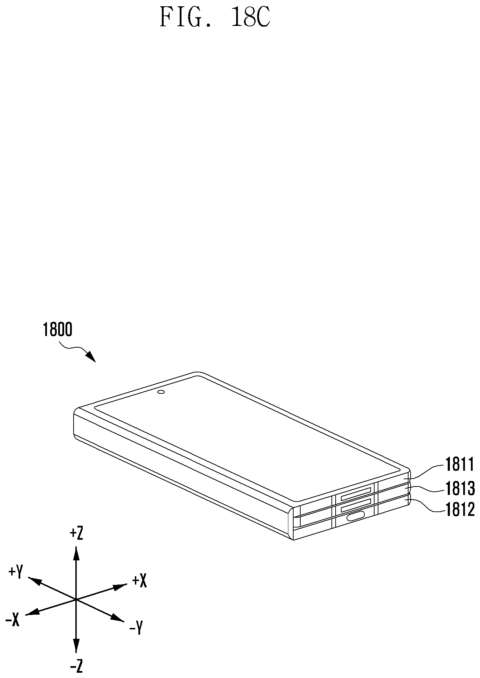

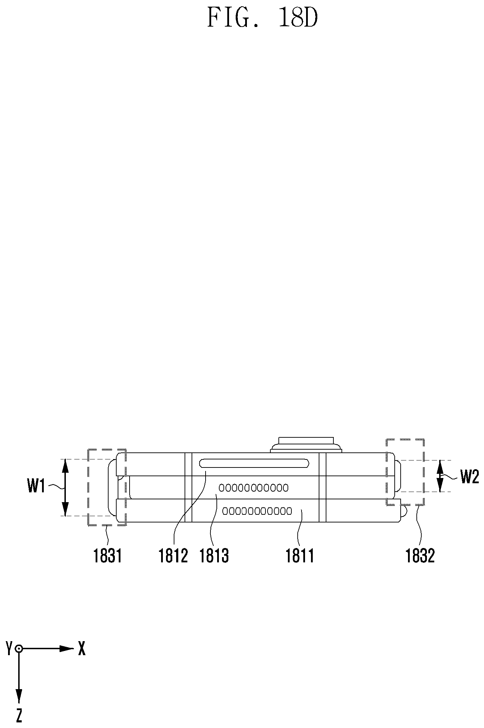

FIGS. 18A, 18B, 18C and 18D are views illustrating an electronic device 1800 according to an embodiment of the disclosure.

The electronic device 1800 according to an embodiment of the disclosure may include a housing 1810, a display 1820, and/or a hinge device 1830.

In an embodiment, the housing 1810 may include a first housing 1811, a second housing 1812, and/or a third housing 1813.

In an embodiment, the display 1820 may include a first region 1821, a second region 1822, and/or a third region 1823.

In an embodiment, the display 1820 may include a flexible display in which at least some regions are bendable and may be changed into a curved surface.

In an embodiment, the first region 1821 of the display 1820 may be disposed in the first housing 1811. The second region 1822 of the display 1820 may be disposed in the second housing 1812. The third region 1823 of the display 1820 may be disposed in the third housing 1813.

In an embodiment, the electronic device 1800 may include multiple hinge devices 1830. For example, the hinge device 1830 may include a first hinge device 1831 and/or a second hinge device 1832.

In an embodiment, the electronic device 1800 may be a device that can be folded with respect to multiple folding axes M1 and M2. For example, the electronic device 1800 may be a device that can be folded or unfolded with respect to a first folding axis M1 and a second folding axis M2.

In an embodiment, the first housing 1811 and the second housing 1812 may be rotatably connected with respect to the first folding axis M1 via the first hinge device 1831.

In an embodiment, the second housing 1812 and the third housing 1813 may be rotatably connected with respect to the second folding axis M2 via the second hinge device 1832.

In an embodiment, the width of the first hinge device 1831 may be greater than the width of the second hinge device 1832. For example, with reference to FIG. 18D, the first width W1 of the first hinge device 1831 may be formed to be greater than the second width W2 of the second hinge device 1832.

In an embodiment, the first hinge device 1831 and the second hinge device 1832 may each include at least one rotation member (e.g., first rotation member 510 in FIG. 7A).

In an embodiment, the rotation member included in the first hinge device 1831 may be formed to have a wider width compared to the rotation member included in the second hinge device 1832.

In an embodiment, the rotation member included in the first hinge device 1831 may include a greater number of catching parts (e.g., first catching part 511 in FIG. 7A) and/or seating parts (e.g., first seating part 512 in FIG. 7A) compared to the rotation member included in the second hinge device 1832.

In an embodiment, the rotation member included in the first hinge device 1831 may include three pairs of catching part-seating part structures. For example, the first rotation member included in the first hinge device 1831 may include a first catching part, a first seating part, and a second catching part. The second rotation member included in the first hinge device 1831 may include a second seating part, a third catching part, and a third seating part. The shape of the first catching part, the second catching part, or the third catching part may be substantially the same as that of the first catching part 511 in FIG. 7A. The shape of the first seating part, the second seating part, or the third seating part may be substantially the same as that of the first seating part 512 in FIG. 7A. When the first region 1821 and the second region 1822 of the display 1820 are unfolded at a preset angle or more, at least one pair among the first catching part and the second seating part, the first seating part and the third catching part, and the second catching part and the third seating part may come into contact with each other, thereby preventing the first region 1821 and the second region 1822 from being unfolded further.

In one embodiment, the rotation member included in the first hinge device 1831 may include four pairs of catching part-seating part structures. For example, the first rotation member may include a first catching part, a first seating part, a second catching part, and a second seating part. The second rotation member included in the first hinge device 1831 may include a third seating part, a third catching part, a fourth seating part, and a fourth catching part.

In an embodiment, the rotation member included in the second hinge device 1832 may include two pairs of catching part-seating part structures. For example, the rotation member included in the second hinge device 1832 may be substantially identical to the first rotation member 510 in FIG. 7A or the second rotation member 520 in FIG. 7B.

If the rotation prevention structure is implemented in a way that the bracket and the protrusion formed at the end of the rotation member come into contact, dust generated due to frequent friction between the bracket and the rotation member may be introduced inside the electronic device.

Additionally, if the rotation prevention structure is implemented in a way that the bracket and the protrusion formed at the end of the rotation member come into contact, the rotation prevention structure may be applied to a relatively vulnerable portion of the rotation member, making the rotation member susceptible to deformation. For example, since the protrusion at the end of the rotation member is formed relatively small, a strong force may be applied to a small area, causing the rotation member to be deformed or broken.

In addition, if the rotation prevention structure is implemented in a way that the bracket and the protrusion formed at the end of the rotation member come into contact, the rotation prevention architecture may be applied to a portion unrelated to the rotation axis of the rotation member, and a force may be applied to the rotation member, so that the rotation axis of the rotation member may be distorted.

An electronic device 400 according to an embodiment of the disclosure may include: a housing 410 including a first housing 411 and a second housing 412; a flexible display 420 disposed in the first housing 411 and the second housing 412; and a hinge device 500 that rotatably connects the first housing 411 and the second housing 412 with respect to each other.

In an embodiment, the hinge device 500 may include a first rotation member 510 connected to the first housing 411 and configured to rotate about a first rotation axis R1, and a second rotation member 520 connected to the second housing 412 and configured to rotate about a second rotation axis R2.

In an embodiment, the first rotation member 510 may include a first catching part 511 and a first seating part 512, and the second rotation member 520 may include a second catching part 521 and a second seating part 522.

In an embodiment, when the housing 410 is in the unfolded state, the first catching part 511 may be positioned to interlock with the second seating part 522, and the second catching part 521 may be positioned to interlock with the first seating part 512 so as to serve as a stopper.

In the electronic device including a hinge device according to an embodiment of the disclosure, when the rotation member is excessively rotated, a force is applied to the catching part and seating part of the rotation member, which are formed relatively thick, so that deformation of the rotation member can be prevented or reduced.

In the electronic device including a hinge device according to an embodiment of the disclosure, the length of the hinge device can be reduced in a direction parallel to the rotation axis since two rotation members are arranged to face each other.

In an embodiment, when the first catching part 511 is positioned to interlock with the second seating part 522, a first force F1 may be applied to the first catching part 511 in a direction parallel to the tangent line TL of a rotation orbit CR of the first catching part 511 centered on the first rotation axis R1.

In an embodiment, when the second catching part 521 is positioned to interlock with the first seating part 512, a second force F2 may be applied to the second catching part 521 in a direction parallel to the tangent line of a rotation orbit of the second catching part 521 centered on the second rotation axis R2.

In the electronic device including a hinge device according to an embodiment of the disclosure, when the rotation member is excessively rotated, a force is applied to the rotation member in a tangential direction of the rotation orbit of the rotation member, so that the rotation axis of the rotation member can be prevented or reduced from being distorted.

In an embodiment, the first catching part 511 and the second catching part 521 may each be formed to have ends in a convex shape.

In an embodiment, the first seating part 512 may include a first catching region 5125 with a concave shape corresponding to the end of the second catching part 521.

In an embodiment, the second seating part 522 may include a second catching region with a concave shape corresponding to the end of the first catching part 511.

In an embodiment, when the first housing 411 and the second housing 412 are unfolded at a preset angle or more, the end of the first catching part 511 may come into contact with the catching region of the second seating part 522, and the end of the second catching part 521 may come into contact with the catching region 5125 of the first seating part 512.

In an embodiment, the first catching part 511 and the first seating part 512 may be formed to protrude from the end portion of the first rotation member 510, and the second catching part 521 and the second seating part 522 may be formed to protrude from the end portion of the second rotation member 520.

In an embodiment, the hinge device 500 may include a bracket 530 on which the first rotation member 510 and the second rotation member 520 are disposed; the bracket 530 may include a first placement region 531 or 534 formed at a position corresponding to the first catching part 511 and the second catching part 521, and a second placement region 532 or 533 formed at a position corresponding to the first seating part 512 and the second seating part 522; the first placement region 531 or 534 may be formed to be more concave than the second placement region 532 or 533.

In an embodiment, the electronic device 500 may include a hinge housing 600 having the bracket 530 disposed thereon and including a first concave part 631 formed on one side and a second concave part 632 formed on the other side; when the first housing 411 and the second housing 412 are in the folded state, the first catching part 511 may come into contact with the first concave part 631, and the second catching part 521 may come into contact with the second concave part 632.

In an embodiment, the flexible display 420 may include a first region 421 disposed in the first housing 411 and a second region 422 disposed in the second housing 412; the case where the first housing 411 and the second housing 412 are unfolded at a preset angle or more may include a case where the first region 421 and the second region 422 are unfolded at 180 degrees or more.

In an embodiment, the hinge device 500 may include a first connection part 541 coupled with the first housing 411 and connected to the first rotation member 510 through a first connection pin 546, and a second connection part 542 coupled with the second housing 412 and connected to the second rotation member 520 through a second connection pin 547.

An electronic device 400 according to an embodiment of the disclosure may include: a first housing 411; a second housing 412; a flexible display 420 including a first region 421 disposed in the first housing 411 and a second region 422 disposed in the second housing 412; and a hinge device 500 that is configured to connect the first housing 411 and the second housing 412 and operate between a folded state in which the first region 421 and the second region 422 face each other and an unfolded state in which the first region 421 and the second region 422 do not face each other.

In an embodiment, the hinge device 500 may include a first rotation member 510 that rotates about a first rotation axis R1, and a second rotation member 520 that rotates about a second rotation axis R2 different from the first rotation axis R1.

In an embodiment, the first rotation member 510 may include a first catching part 511 and a first seating part 512 formed at a first end 510A facing the second rotation member 520 in the unfolded state; the second rotation member 520 may include a second seating part 522 and a second catching part 521 formed at a second end 520A facing the first rotation member 510 in the unfolded state.

In an embodiment, when the first region 421 and the second region 422 are unfolded at a preset angle or more, the first catching part 511 may come into contact with the second seating part 522.

In an embodiment, the first catching part 511 and the second catching part 521 may include an identical shape, and the first seating part 512 and the second seating part 522 may include an identical shape.

In an embodiment, the first rotation member 510 may include a third end 510B formed on the other side of the first end S10A; the second rotation member 520 may include a fourth end 520B formed on the other side of the second end 520A; in the folded state, the distance between the first end 510A and the second end 520A may be greater than the distance between the third end 510B and the fourth end 520B.

In an embodiment, the first catching part 511 may include a first surface 511A corresponding to a first direction toward the flexible display 420; the second seating part 522 may include a second surface 522A corresponding to a second direction different from the first direction; at least a portion of the first surface 511A and at least a portion of the second surface 522A may be arranged to overlap each other in the unfolded state.

In an embodiment, the first surface 511A of the first catching part 511 and the second surface 522A of the second seating part 522 may have an inclined shape with respect to the flexible display 420 in the unfolded state.

In an embodiment, when the first region 421 and the second region 422 are unfolded at a preset angle or more, the first seating part 512 may come into contact with the second catching part 521.

In an embodiment, the second catching part 521 may include a third surface 521A corresponding to the first direction 511A toward the flexible display 420; the first seating part 512 may include a fourth surface 512A corresponding to the second direction different from the first direction; at least a portion of the third surface 521A and at least a portion of the fourth surface 512A may be arranged to overlap each other in the unfolded state.

In an embodiment, the hinge device 500 may include a bracket 530 on which the first rotation member 510 and the second rotation member 520 are disposed; the bracket 530 may include a first portion 531 formed at a position corresponding to the first catching part 511, and a second portion 532 formed at a position corresponding to the second seating part 522; in the unfolded state, the distance between the first rotation member 510 and the first portion 531 may be different from the distance between the second rotation member 520 and the second portion 532.

In an embodiment, the first portion 531 may include a first curved surface 531A, the second portion 532 may include a second curved surface 532A, and the first curved surface 531A may have a larger radius of curvature than the second curved surface 532A.

In an embodiment, the bracket 530 may include a third portion 533 formed at a position corresponding to the first seating part 512, and a fourth portion 534 formed at a position corresponding to the second catching part 521; the third portion 533 may have the same shape as the second portion 532, and the fourth portion 534 may have the same shape as the first portion 531.

In an embodiment, the bracket 1630 may include a first support 1631 and a second support 1632; when the first region 421 and the second region 422 are unfolded at a preset angle or more, the first seating part 1612 may come into contact with the first support part 1631, and the second catching part 1621 may come into contact with the second support part 1632.

An electronic device 400 according to an embodiment of the disclosure may include: a housing 410 including a first housing 411 and a second housing 412; a flexible display 420 disposed in the first housing 411 and the second housing 412; and a hinge device 500 that rotatably connects the first housing 411 and the second housing 412 with respect to each other.

In an embodiment, the hinge device 500 may include a first rotation member 510 that is connected to the first housing 411 and rotates about a first rotation axis R1, and a second rotation member 520 that is connected to the second housing 412 and rotates about a second rotation axis R2 different from the first rotation axis R1.

In an embodiment, the first rotation member 510 may include a first catching part 511 and a first seating part 512 formed to protrude from the first end 510A; the second rotation member 520 may include a second catching part 521 and a second seating part 522 formed to protrude from the second end 520A.

In an embodiment, the first seating part 512 may be formed at a distance from the first catching part 511 in a direction of the first rotation axis R1 and include a concave shape corresponding to the second catching part 521; the second seating part 522 may be formed at a distance from the second catching part 521 in a direction of the second rotation axis R2 and include a concave shape corresponding to the first catching part 511.

In an embodiment, when the angle between the upper surface (e.g., the surface through which the first line X1 in FIG. 13B passes) of the first rotation member 510 and the upper surface (e.g., the surface through which the first line X1 in FIG. 13C passes) of the second rotation member 520 is greater than or equal to a preset angle, at least one pair among the first catching part 511 and the second seating part 522, and the second catching part 521 and the first seating part 512 may be in contact with each other.

The technical objectives to be achieved in the disclosure are not limited to those mentioned above, and other technical objectives not mentioned will be clearly understood by a person having ordinary skill in the art to which the disclosure pertains.

The effects that can be obtained from the disclosure are not limited to those mentioned above, and other effects not mentioned will be clearly understood by a person having ordinary skill in the art to which the disclosure pertains.

The electronic device according to an embodiment of the disclosure may be one of various types of devices. The electronic device may include, for example, a portable communication device (e.g., smartphone), a computer device, a portable multimedia device, a portable medical instrument, a camera, a wearable device, or a home appliance. The electronic device according to an embodiment of the disclosure is not limited to those described above.

An embodiment of the disclosure and terms used therein are not intended to limit the technical features described in the disclosure to specific embodiments, and should be understood as including various modifications, equivalents, or substitutes of a corresponding embodiment. With regard to the description of the drawings, similar reference numerals may be used to refer to similar or related elements. A singular form of a noun corresponding to a specific item may include one or multiple instances of the item unless the relevant context clearly indicates otherwise. In the disclosure, each of phrases such as "A or B", "at least one of A and B", "at least one of A or B", "A, B or C", "at least one of A, B and C", and "at least one of A, B or C" may include any one of or all possible combinations of the items enumerated together in the corresponding one of the phrases. Terms such as "1st" and "2nd", or "first" and "second" may be used to simply distinguish a corresponding component from another, and does not limit the components in other aspect (e.g., importance or order). When an element (e.g., first element) is referred to, with or without the term "operably" or "communicatively", as "coupled to/with" or "connected to/with" another element (e.g., second element), this means that the element may be connected or coupled to the other element directly (e.g., wiredly), wirelessly, or via a third element.

The term "module" used in an embodiment of the disclosure may include a unit implemented in hardware, software, or firmware, and may be used interchangeably with other terms, for example, "logic", "logic block", "component", or "circuit". A module may be a single integral component, or a minimum unit or part thereof performing one or more functions. For example, according to an embodiment, a module may be implemented in a form of an application-specific integrated circuit (ASIC).

An embodiment of the disclosure may be implemented as software (e.g., programs 140) including one or more instructions that are stored in a storage medium (e.g., internal memory 136 or external memory 138) readable by a machine (e.g., electronic device 101). For example, a processor (e.g., processor 120) of the machine (e.g., electronic device 101) may invoke at least one of the one or more instructions stored in the storage medium to execute it. This allows the machine to be operated to perform at least one function according to the invoked at least one instruction. The one or more instructions may include a code generated by a complier or a code executable by an interpreter. The machine-readable storage medium may be provided in the form of a non-transitory storage medium. Here, the term "non-transitory" simply means that the storage medium is a tangible device and does not include a signal (e.g., electromagnetic wave), but this term does not distinguish whether data is stored semi-permanently or temporarily in the storage medium.

The method according to an embodiment of the disclosure may be provided by being included in a computer program product. The computer program product may be traded as a commodity between a seller and a purchaser. A computer program product may be distributed in the form of a machine-readable storage medium (e.g., compact disc read only memory (CD-ROM)) or be distributed online (e.g., download or upload) directly between two user devices (e.g., smartphones) through an application store (e.g., PlayStore ^{™}). For on-line distribution, at least a portion of the computer program product may be temporarily stored or temporarily created in a machine readable storage medium such as a memory of a manufacturer's server, an application store's server, or a relay server.

According to an embodiment, each component (e.g., module or program) of the above-described components may include a single entity or multiple entities, and some of the multiple entities may be separately arranged on other components. According to an embodiment, one or more components or operations may be omitted from the above-described components, or one or more other components or operations may be added. Alternatively or additionally, a plurality of components (e.g., modules or programs) may be integrated into a single component. In this case, the integrated component may perform one or more functions of each of the plurality of components in the same or similar manner as they are performed by a corresponding one of the plurality of components before the integration.

According to an embodiment, operations performed by a module, a program, or another component may be carried out in sequence, in parallel, by repetition, or heuristically, or one or more of the operations may be executed in a different order or may be omitted, and one or more other operations may be added.

## Claims

1. An electronic device (400) comprising:
a housing (410) comprising a first housing (411) and a second housing (412);
a flexible display (420) disposed in the first housing and the second housing; and
a hinge device (500) that connects the first housing and the second housing to be rotatable with respect to each other,
wherein the hinge device comprises:
a first rotation member (510) coupled to the first housing, the first rotation member configured to rotate about a first rotation axis (R1); and
a second rotation member (520) coupled to the second housing, the second rotation member configured to rotate about a second rotation axis (R2);
wherein the first rotation member comprises a first catching part (511) and a first seating part (512),
wherein the second rotation member comprises a second catching part (521) and a second seating part (522), and
wherein the first catching part is positioned to interlock with the second seating part and the second catching part is positioned to interlock with the first seating part so as to function as a stopper when the housing is in an unfolded state.

2. The electronic device of claim 1, wherein a first force (F1) is applied to the first catching part in a direction parallel to a tangent (TL) of a rotation orbit (CR) of the first catching part centered on the first rotation axis when the first catching part is positioned to interlock with the second seating part, and
wherein a second force is applied to the second catching part in a direction parallel to a tangent of the rotation orbit of the second catching part centered on the second rotation axis when the second catching part is positioned to interlock with the first seating part.

3. The electronic device of claim 1, wherein the first catching part and the second catching part each have ends formed in a convex shape,
wherein the first seating part comprises a first catching region (5125) having a concave shape corresponding to the end of the second catching part,
wherein the second seating part comprises a second catching region having a concave shape corresponding to the end of the first catching part, and
wherein the first catching part is in contact with the second catching region of the second seating part and the second catching part is in contact with the first catching region of the first seating part when the first housing and the second housing are unfolded beyond a predetermined angle.

4. The electronic device of claim 1, wherein the hinge device further comprises a bracket (530) on which the first rotation member and the second rotation member are disposed, and
wherein the bracket comprises:
a first portion (531) and a fourth portion (534) formed at positions respectively corresponding to the first catching part and the second catching part; and
a second portion (532) and a third portion (533) formed at positions respectively corresponding to the first seating part and the second seating part,
wherein the first portion and the fourth portion are formed to be more concave than the second portion and the third portion.

5. The electronic device of claim 4, further comprising a hinge housing (600) on which the bracket is disposed and comprises a first concave part (631) formed on one side and a second concave part (632) formed on the other side,
wherein the first catching part contacts the first concave part when the first housing and the second housing are folded, and
wherein the second catching part contacts the second concave part when the first housing and the second housing are folded.

6. The electronic device of claim 1, wherein the flexible display further comprise s a first region (421) disposed in the first housing and a second region (422) dispose d in the second housing,
wherein the hinge device is configured to connect the first housing and the sec ond housing and operate between a folded state in which the first region and the sec ond region face each other and an unfolded state in which the first region and the se cond region do not face each other,
wherein the first catching part and the first seating part are formed at a first e nd (510A) facing the second rotation member when the housing is in the unfolded sta te,
wherein the second seating part and the second catching part are formed at a second end (520A) facing the first rotation member when the housing is in the unfold ed state,
wherein when the first region and the second region are unfolded at a preset a ngle or more, the first catching part comes into contact with the second seating part, and the second catching part comes into contact with the first seating part, and
wherein the case where the first housing and the second housing are unfolded beyond the predetermined angle comprises the case where the first region and the second region are unfolded more than 180 degrees.

7. The electronic device of claim 1, wherein the first catching part and the first seating part are formed to protrude from a first end (510A) of the first rotation mem ber,
wherein the second catching part and the second seating part are formed to protrude from a second end (520A) of the second rotation member,
wherein the first seating part is formed at a distance from the first catching part in a direction of the first rotation axis and includes a concave shape corresponding to the second catching part, and
wherein the second seating part is formed at a distance from the second catching part in a direction of the second rotation axis and includes a concave shape corresponding to the first catching part.

8. The electronic device of claim 1, further comprising:
a first connection part (541) coupled to the first housing and connected to the first rotation member by a first connection pin (546), and
a second connection part (542) coupled to the second housing and connected to the second rotation member by a second connection pin (547).

9. The electronic device of claim 1, wherein:
the first catching part and the second catching part include an identical shape; and
the first seating part and the second seating part include an identical shape.

10. The electronic device of claim 6, wherein:
the first rotation member includes a third end (510B) formed on the other side of the first end;
the second rotation member includes a fourth end (520B) formed on the other side of the second end; and
in the folded state, a distance between the first end and the second end is greater than a distance between the third end and the fourth end.

11. The electronic device of claim 1, wherein:
the first catching part and the second catching part respectively include a first surface (511A) and a third surface (521A) corresponding to a first direction toward the flexible display;
the first seating part and the second seating part respectively include a fourth surface (512A) and a second surface (522A) corresponding to the second direction different from the first direction; and
when the housing is in the unfolded state, at least a portion of the first surface and at least a portion of the second surface are arranged to overlap each other, and at least a portion of the third surface and at least a portion of the fourth surface are arranged to overlap each other.

12. The electronic device of claim 11, wherein the first surface of the first catching part and the second surface of the second seating part have an inclined shape with respect to the flexible display in the unfolded state.

13. The electronic device of claim 4,
when the housing is in the unfolded state, a distance between the first rotation member and the first portion is different from a distance between the second rotation member and the second portion.

14. The electronic device of claim 4, wherein:
the first portion includes a first curved surface;
the second portion includes a second curved surface; and
the first curved surface has a larger radius of curvature than the second curved surface.

15. The electronic device of claim 6, wherein the hinge device further includes a bracket (530) on which the first rotation member and the second rotation member are disposed,
wherein the bracket includes a first support and a second support, and
wherein when the first region and the second region are unfolded at the preset angle or more, the first seating part comes into contact with the first support, and the second catching part comes into contact with the second support.
